# EUROPEAN PATENT APPLICATION

(11) **EP 4 704 496 A1**
(43) Date of publication of application: **04.03.2026**
(21) Application number: 24197348.6
(22) Date of filing: 29.08.2024
(51) Int. Cl.: H05K 1/09, C09D 11/52, H05K 3/40, H05K 1/11, H05K 3/46, H05K 3/00, H05K 1/02

(54) **COMPONENT CARRIER AND METHOD FOR MANUFACTURING A COMPONENT CARRIER**

(71) Applicant: AT & S Austria Technologie & Systemtechnik Aktiengesellschaft, 8700 Leoben-Hinterberg (AT)
(72) Inventor: DONATELLO, Daniele, 8700 Leoben (AT); GROBER, Gernot, 8741 Weißkirchen (AT)
(74) Representative: Donatello, Daniele

(57) **Abstract**

The present invention relates to a component carrier (100, 200, 300, 400) a method for manufacturing thereof, wherein the component carrier (100, 200, 300, 400) comprises a stack (101) comprising at least one electrically insulating layer structure (30) and at least two electrically conductive layer structures (10, 20), at least one electrically conductive element (40), said at least one electrically conductive element (40) passing through said at least one electrically insulating layer structure (30), preferably in stacking direction (Z). Said at least one electrically conductive element (40) comprises an electrically conductive paste (42) provided in a cavity (41) being located at least partially within the at least one electrically insulating layer structure (30), said electrically conductive paste (42) being in contact with said at least two electrically conductive layer structures (10, 20), wherein the center of gravity (91) of one vertical extremity of the at least one electrically conductive element (40) is misaligned with respect to the center of gravity (92) of the opposed other vertical extremity of said at least one electrically conductive element (40).

## Description

### TECHNICAL BACKGROUND

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, interconnecting two or more layers of a component carrier or component carriers using a paste, in particular one above the other (in the Z-direction), may be challenging.

There may be a need to provide an interconnection between at least two or more layers of a component carrier or component carriers using a paste in an efficient, reliable, and robust manner.

In order to achieve the object defined above, a component carrier and a method of manufacturing the component carrier according to the independent claims are provided. The dependent claims describe advantageous embodiments.

### FIELD OF THE INVENTION

The present invention generally relates to a component carrier comprising a stack, the stack comprising at least one electrically insulating layer structure and at least two electrically conductive layer structures, at least one electrically conductive element, said at least one electrically conductive element passing through said at least one electrically insulating layer structure. Said at least one electrically conductive element comprises an electrically conductive paste provided in a cavity being located at least partially within the at least one electrically insulating layer structure, said electrically conductive paste being in contact with said at least two electrically conductive layer structures, wherein the center of gravity of one vertical extremity of the at least one electrically conductive element is misaligned with respect to the center of gravity of the opposed other vertical extremity of said at least one electrically conductive element.

Further, the present invention relates to a method for manufacturing a component carrier as described above.

According to a first aspect of the present invention, a component carrier is provided, wherein the component carrier comprises a stack comprising at least one electrically insulating layer structure and at least two electrically conductive layer structures, at least one electrically conductive element, said at least one electrically conductive element passing through said at least one electrically insulating layer structure, preferably in stacking direction. Said at least one electrically conductive element comprises an electrically conductive paste provided in a cavity being located at least partially within the at least one electrically insulating layer structure, said electrically conductive paste being in contact with said at least two electrically conductive layer structures, wherein the center of gravity of one vertical extremity of the at least one electrically conductive element is misaligned with respect to the center of gravity of the opposed other vertical extremity of said at least one electrically conductive element.

According to a second aspect of the present invention, a method of manufacturing a component carrier is provided, wherein the method comprises the steps of: forming a stack comprising at least one electrically insulating layer structure and at least two electrically conductive layer structures, forming at least one electrically conductive element, said at least one electrically conductive element passing through said at least one electrically insulating layer structure, preferably in stacking direction. Said at least one electrically conductive element comprises an electrically conductive paste provided in a cavity being located at least partially within the at least one electrically insulating layer structure, said electrically conductive paste being in contact with said at least two electrically conductive layer structures, wherein the center of gravity of one vertical extremity of the at least one electrically conductive element is misaligned with respect to the center of gravity of the opposed other vertical extremity of said at least one electrically conductive element.

A component carrier according to the first aspect of the present invention is created, in which at least one cavity is located within an electrically insulating layer structure, said cavity is at least partially vertically extending through the entire thickness of said electrically insulating layer structure and filled with an electrically conductive paste, thereby creating at least one electrically conductive element, which is electrically connecting two adjacent electrically conductive layer structures located on opposed main surfaces of said electrically insulating layer structure. The at least one electrically conductive element is in direct contact with the electrically insulating layer structure and the two adjacent respective electrically conductive layer structures. During manufacturing of the component carrier, the at least two electrically conductive layer structures are mechanically connected to the electrically insulating layer structures as well as to the at least one electrically conductive element by applying elevated temperature, for example higher than 80 °C, and/or elevated pressure, for example higher than 2 bars. Due to the physical properties (for example the Young's modulus, incompressible state, etc.) and the amount (for example occupying a volume greater than the volume of the cavity, in particular having a volume (Vol-%) of at least 100%, 110%, 120%, 130%, 140% or 150%, but preferably less the 160%, 170%, 180% 190% or 200% of the original cavity volume) of the electrically conductive paste, and the deformability (in particular due to deformable state during the component carrier manufacturing process, more in particular due to a not-totally cured state) of the electrically insulating layer structure, and the freedom of the layer structures to planarly (slightly) slide one to each other (for example the electrically conductive layer structures and/or the electrically insulating layer structure), the electrically conductive element deforms by shifting and/or pushing the material of the at least one electrically conductive element in at least one direction being transverse to the stacking direction, resulting in that the center of gravity of one vertical extremity of the at least one electrically conductive element is misaligned with respect to the center of gravity of the opposed other vertical extremity of said at least one electrically conductive element. The deformation of the at least one electrically conductive element decreases, in particular eliminates, internal mechanical tension inside the at least one electrically conductive element and thereby ensuring a highly reliable electrical and mechanical connection of two adjacent electrically conductive layer structures. Said internal electrical and mechanical connection is enhanced by the compression of the electrically conductive paste material during the manufacturing of the component carrier, assuring a proper compact electrically conductive element widely adhering the at least two electrically conductive layer structures.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from proper art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaO₂, AgAlO₂, LiGaTe₂, AgInSe₂, CuFeS₂, BeO.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Further-more, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOa), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art.

In at least one embodiment, the at least one electrically conductive layer structure of the component carrier comprises at least one of the following group consisting of: copper, aluminum, nickel, silver, gold, palladium, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT), respectively.

In the context of the present application, the term "electrically insulating layer structure" may denote a layer structure which is electrically non-conductive.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "layer structure" may particularly denote a continuous layer, a patterned layer or a plurality of non-consecutive islands within a common plane. A layer structure can comprise at least one protruding element such as, for example, one or more solder bumps, copper bumps, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "electrically conductive element" may particularly denote an element of the component carrier that provides and/or facilitates the transmission of electrical signals, and which is configured to electrically connect various components and/or layer structures within the component carrier. Electrically conductive elements are, for example, conductive traces, pads and vias.

The at least one electrically conductive element of a component carrier according to the first aspect of the present invention may in particular be a small hole in the component carrier which is filled with electrically and/or thermally conductive material for establishing an electrical connection between different layer structures stacked above each other in stacking direction with an insulating layer structure in between. The at least one electrically conductive element may in particular be a via, preferably a via which establishes an electrical connection in thickness direction or stacking direction between at least two electrically conductive layer structures of a stack and/or component carrier.

In the context of the present application, the term "electrically conductive paste" may particularly denote a type of material that is applied in a paste form and is used to create electrically connections within the component carrier, in particular between at least two electrically conductive layer structures. An electrically conductive paste may comprise electrically conductive particles, such as, for example silver, copper, bismuth, and/or carbon particles and/or a combination thereof, wherein the electrically conductive particles may in particular be suspended in a binder or an adhesive medium. The size of the electrically conductive particles may be in the range of 500 nm to 30 µm. The electrically conductive paste may comprise matrix material configured for hosting the electrically conductive particles. In at least one embodiment, in particular in a preferred embodiment, the matrix material may be a polymeric material, in particular an organic polymeric material, for example an (epoxy) resin. Also, a solder paste and/or sinter paste may be an "electrically conductive paste" in the context of the present application.

The electrically conductive paste may have advantageous properties with respect to the present invention, in particular advantageous viscosities, an advantageous curing/sintering behavior and as well advantageous electrically conductivity. In at least one embodiment, the electrical conductivity of the electrically conductive paste may be larger than 5*10⁵ S/m, in particular larger than 10⁷ S/m, for example.

In at least one embodiment of a component carrier according to the present invention the electrically conductive element, in particular the electrically conductive paste, may be deformable, in particular in a state not being cured or not being totally cured. After finishing the component carrier, the electrically conductive element may in particular be non-deformable since the resin of the conductive paste may be (totally) cured. These properties of the electrically conductive element, in particular of the electrically conductive paste, in particular support the above-described advantageous adaptation of the shape of the conductive element during production of the component carrier, in particular the adaptation of the shape of the conductive paste under pressure and/or temperature.

In the context of the present application, the term "cavity" may particularly denote a recess or hollow space having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In the context of the present application, the term "inclination" particularly refers to the inner geometric angle between the lateral wall of the electrically insulating layer structure delimiting the cavity and a base plane (here: the contacting plane), wherein the "inclination" indicates the tilt or slope of the lateral wall relative to the base plane (here the contacting plane) as reference plane. The inclination indicates how much the lateral wall deviates from the contacting plane. The inclination is measured as the inner angle between the inclined lateral wall and the corresponding base plane (here: the contacting plane).

In the context of the present application, the term "contacting plane" may refer in particular to a (virtual) plane delimiting the cavity from above or from below, in particular in thickness direction of the stack. In particular, the term "contacting plane" may refer to a main surface, in particular to an (in theory) ideal planar main surface, of one of the electrically conductive layer structures facing and overlapping the cavity and in particular delimiting the cavity from above or from below. Said surface may in particular be planar. However, this is not mandatory in reality. In particular in a contact area said "contacting plane" may be slightly curved and/or comprise for example one or more dimples or the like.

In the context of the present application, with the term "center of gravity of one vertical extremity of at least one electrically conductive element" it is meant the center of gravity of the planar figure defined by said extremity, in particular the planar figure at the extremity defined by the boundary profile of at least one electrically conductive element along a plane perpendicular to the stacking direction, more in particular said plane passing through said center of gravity. As commonly known, the center of gravity of such figure is found out in the same way as that of solid bodies. The center of gravity of such figure may particularly refer to the arithmetic mean position of all points located in and/or associated to a surface of an object. The center of gravity of a planar figure is also known as geometric center or center of figure. The term "center of gravity" is also known as "centroid" or "geometric center". In an example, the center of gravity of a convex object or surface lies inside the circumference of said object or surface.

In the context of the present application, the term "extremity" may particularly refer to a point or portion of an object furthest away from its center. For instance, an object having an elongated shape, for example a tube or cylinder having an axial elongation larger than the diameter, has two extremities, wherein the extremities are located on opposed sites of the cylinder (when considering axial elongation). The extension of the extremity may correspond to a planar portion of an object, in particular an electrically conductive element, exposing from one electrically insulating layer structure, preferably or alternatively facing and/or contacting one adjacent layer, for example one of the at least two electrically conductive layer structures. Additionally, the extension of the opposed extremity may correspond to a further planar potion of the same object located on the opposed side contacting another adjacent layer, for example the other of the at least two electrically conductive layer structures. In an example, the extremity of an electrically conductive element and the other extremity of the same electrically conductive element on opposed side have respective surfaces, wherein the surface associated to the extremity of an electrically conductive element and the respective other surface associated to the other extremity of the same electrically conductive element on opposed side have a parallel and/or co-planar alignment.

In the context of the present application, the term "the center of gravity of one vertical extremity of the at least one electrically conductive element is misaligned with respect to the center of gravity of the opposed other vertical extremity of said at least one electrically conductive element" may in particular refer to a circumstance when creating a vertical axis through one center of gravity of one vertical extremity of the at least one electrically conductive element, wherein the direction of the virtual straight line is parallel to stacking direction, the center of gravity of the opposed other vertical extremity of said at least one electrically conductive element is not located on / does not correspond to said vertical axis. In other words, only one center of gravity of the two vertical extremities of the at least one electrically conductive element is an element of a vertical axis, according to mathematical definition. Additionally or alternatively, the center of gravity of one vertical extremity of the at least one electrically conductive element and the center of gravity of the opposed other vertical extremity of said at least one electrically conductive element are distanced in a direction perpendicular to stacking direction.

In the context of the present application the term "perpendicular free portion" may in particular denote the portion of the conductive element not fully overlapping along the stack thickness direction from one extremity to the opposed extremity of the conductive element.

In the context of the present application the expression "in a central area" or "central area" in particular refers to approximately a zone around the middle between the upper side and the bottom side (between the two contact areas) in thickness direction, wherein the middle zone or central preferably extends about 10 % to 75 % of the layer thickness in thickness direction of the surrounding insulating layer structure. Additionally or alternatively, the central area may refer to approximately a zone around the middle between a lateral side and the opposed other lateral side (in lateral direction), wherein the middle zone or central preferably extends about 10 % to 75 % of a lateral extension of a (geometric) body, for example an electrically conductive element, in lateral direction of the surrounding electrically conductive layer structure or electrically insulating layer structure.

### Description of Exemplary Embodiments

According to an embodiment, the center of gravity of one vertical extremity of the at least one electrically conductive element is misaligned with respect to the center of gravity of the opposed other vertical extremity of said at least one electrically conductive element from a planar view of the stack, in particular in the plane of main extension of the component carrier or perpendicular to stacking direction. Additionally, the misalignment of the may be in two directions perpendicular to stacking direction (i.e. along both each x-, y-(lateral) direction), wherein also the two directions perpendicular to stacking direction are perpendicular to each other and not being in same direction to stacking direction. In other words, the stacking direction and the two directions perpendicular to stacking direction are creating a three-dimension Cartesian coordinate system. This may bring the advantage of compensating shear forces applied to the at least one electrically conductive element in at least one, in particular in two, directions being perpendicular to stacking direction. Thereby an electrically connection may be ensured having high and sufficient electrical conductivity for transmitting electrical signals and/or current and being flexible to withstand shear forces applied during manufacturing process steps.

According to a further embodiment of the present invention, the misalignment comprises a planar offset between the center of gravity of one vertical extremity of the at least one electrically conductive element and the center of gravity of the opposed other vertical extremity of said at least one electrically conductive element. In an example, the planar offset may be smaller than 70 µm, in particular smaller than 50 µm. In another example, the planar offset may be smaller than the largest extension of the vertical extremity of the at least one electrically conductive element and/or the other vertical extremity of said at least one electrically conductive element considering a direction perpendicular to stacking direction, for example the diameter of the vertical extremity of the at least on electrically conductive element. Still, in a further example, the planar offset may be in the range from 2 µm to 50 µm. The planar offset may be a measurable feature of the electrically conductive element indicating the adaptability of the electrically conductive element when shear forces are applied. The bigger the value, the more forces, in particular shear forces may be compensated especially in case of higher amount of conductive paste with respect to the available volume in the cavity. Even with a planar offset value larger than 10 µm, a reliable mechanical and/or electronic connection may be ensured, due to flexible properties of the electrically conductive paste.

According to another embodiment of the present invention, the misalignment is at least partially along the stack thickness direction, in particular wherein the axis passing through the center of gravity of each one of the two vertical extremities of the at least one electrically conductive element is inclined with respect to one of the stack main surfaces of an angle different from 90°.

According to a further embodiment of the present invention, the misalignment at least partially along the stack thickness direction with respect to one of the stack main surfaces is of a value within the range of 50° and 89°. Use of electrically conductive paste in combination with the applied manufacturing method by allowing a planar slide of different layer structures, for example an electrically conductive layer structure and/or an electrically insulating layer structure, causing shear forces, the at least one electrically conductive element may be able to adapt and/or compensate the force by deformation of the at least one electrically conductive element resulting in an inclination. Thus the at least one electrically conductive element may ensure a reliable mechanical and/or electrical interconnection between two adjacent electrically conductive layer structures.

According a preferred embodiment of the present invention, the at least one electrically conductive element comprises a lateral wall comprising several portions, wherein at least two of said portions, in particular the opposed ones from the planar view, are inclined toward the same direction along the stack thickness direction. Such a geometrical form may be the footprint of the planar sliding of the layer structures of the stack, biasing the lateral walls of the at least one electrically conductive element, in particular the opposed one, toward the same inclination along the stack thickness direction, in particular toward the sliding direction of the layer structure closer and/or in contact with the respective extremity(ies). However, the use of electrically conductive paste material may adapt to the applied shear forces resulting in a reliable electrically and/or mechanical connection (between adjacent electrically conductive layer structures).

According to another embodiment of the present invention, the at least one electrically conductive element comprises a lateral wall comprising several portions, wherein at least two of said portions, in particular the opposed ones from the planar view, are inclined toward the opposed direction along the stack thickness direction. During pressing process, the electrically conductive paste may be partially compressed and portions of the paste material may push in radially outward direction thereby forming the opposed portions of the lateral wall having inclinations in opposed direction (when considering a cross sectional view). In an example, the at least one electrically conductive element may have a frustoconical shape. This shape may be accentuated through a frustoconical shape of the cavity before its deformation by the respective conductive paste. Even if the electrically conductive paste may be partially compressed, the electrically conductive element may ensure reliable electrically conductivity configured for transmitting electrical signals and/or current.

According to a preferred embodiment of the present invention, the at least two of said portions (of the lateral wall of the at least one electrically conductive element) are inclined with different inclinations one to each other with respect to one of the stack main surfaces. This may bring the advantage of withstanding different shear forces and/or shear rates applied to the at least one electrically conductive element resulting in different respective inclinations. The at least one electrically conductive element comprising electrically conductive paste may adapt by itself resulting in different respective inclinations and thereby reducing the internal stress of the at least one electrically conductive element.

According to another embodiment of the present invention, the planar shape of at least one of the two vertical extremities of the at least one electrically conductive element comprises at least one, eventually at least two, irregularities externally protruding from the overall planar shape, the center of gravity of said planar shape being decentered from the respective natural position of the overall planar shape toward said irregularity. Applying shear forces on at least one vertical extremity of the at least one electrically conductive element may result in a local deformation of the extremity thereby creating a randomly deformed shape of the vertical extremity. For instance, a circular or elliptical shape of the at least one vertical extremity of the at least one electrically conductive element may create a circumferential shape like a bibigon when considering a planar view or top view after influence of shear forces. In another example, shape of the at least one extremity of the at least one electrically conductive element may be an irregular shape. This may result in a dislocation of the related center of gravity of the related vertical extremity, since the surface and or area of the extremity is enlarged. Nevertheless, the shift of the related center of gravity of the at least one vertical extremity of the at least one electrically conductive element may positively interfere the mechanical and/or electrical performance of the at least one electrically conductive element.

In the context of the present application, the term "natural position" may particularly refer to the position of the center of gravity assuming the planar shape of the extremity without the irregularity. As irregularity it is meant a local diverging portion of the boundary planar profile of the extremity with respect to the overall boundary profile of the extremity. Preferably, the (circumferential) extension of the diverging portion may be of less than 40%, more preferably less than 20%, of the (circumferential) extension of the whole boundary profile of the vertical extremity. After shear forces are applied, the circular shape of the extremity of the electrically conductive element may deform to an oval shape.

According to a further embodiment of the present invention, the planar shape of at least one of the two vertical extremities of the at least one electrically conductive element comprises at least one, eventually at least two, irregularities internally recessing inside the overall planar shape, the center of gravity of said planar shape being decentered from the respective natural position of the overall planar shape away the irregularity. Applying shear forces on at least one vertical extremities of the at least one electrically conductive element may result in a local deformation of the extremity thereby creating randomly deformed shapes of the vertical extremity. For instance, a circular or elliptical shape of the at least one vertical extremity of the at least one electrically conductive element may create a circumferential shape like a circular segment or a lune when considering a planar view or top view. This may result in a dislocation of the related center of gravity of the related vertical extremity, since the surface and or area of the extremity is narrowed. Nevertheless, the shift of the related center of gravity of the at least one vertical extremity of the at least one electrically conductive element may not interfere the mechanical and/or electrical performance of the at least one electrically conductive element in a bad way.

According to a preferred embodiment of the present invention, the planar extension, in particular the average diameter, of one vertical extremity of the at least one electrically conductive element is different with respect to the corresponding planar extensions, in particular the average diameter, of the opposed other extremity of said at least one electrically conductive element. During manufacturing of the component carrier, in particular during pressing step, local forces may act on different portions of the at least one electrically conductive element thereby shearing with different forces on respective different portions. Due to the deformability property of the electrically conductive paste, a reliable mechanical and/or electrical connection of the at least one electrically conductive element may be ensured.

According to another embodiment of the present invention, said electrically conductive paste being sandwiched between said at least two electrically conductive layer structures. This may bring the advantage of reducing the overall extension of the component carrier in stacking direction, since less electrically insulating layers are needed. Additionally or alternatively, the electrically conductive paste may ensure a reliable electrical and/or mechanical connection to the at least two electrically conductive layer structures independent from the thickness of the electrically insulating layer structure in with the at least one electrically conductive element is located. For example, the thickness of the electrically insulating layer structure may be higher than 30 µm. In another example, the thickness of the electrically insulating layer structure may be smaller than 800 µm.

According to a further embodiment of the present invention, the at least one of said two electrically conductive layer structures is provided on one of the main surfaces of the at least one electrically insulating layer structure. This may bring the advantage of reducing the risk of delamination since material of the electrically conducting layer structure has good interaction, for example adhesion, with the material of the electrically insulating layer structure.

According to a further embodiment of the present invention, at least one of said two electrically conductive layer structures is at least partially embedded in the at least one electrically insulating layer structure, in particular exposing at one of the main surfaces of said at least one electrically insulating layer structure. This may bring the advantage of shortening the distance in stacking direction between two adjacent electrically conductive layer structure. Additionally, the adhesion of the electrically conductive layer structure to the electrically insulating layer structure may be enhanced, since the electrically conductive layer structure is in direct contact with the electrically insulating layer structure with at least three walls.

According to another embodiment of the present invention, the the misalignment value between the center of gravity of one vertical extremity of and the center of gravity of the opposed other vertical extremity of the at least one electrically conductive element is of a value resulting in a ratio between 5% to 60% with respect to the average lateral extension of said at least one electrically conductive element. This may bring the advantage of having a higher alignment tolerance during manufacturing of the adjacent at least two electrically conductive layer structures, since the connection of the adjacent at least two electrically conductive layer structures by the at least one electrically conductive element may compensate a transversal shift of the at least two electrically conductive layer structures relative to each other.

According to a preferred embodiment of the present invention, said at least one electrically conductive element laterally extends along an irregular profile, in particular defining valleys. Since the lateral wall of the at least one electrically conductive element is defined by the electrically conductive paste affecting the cavity lateral wall in the adjacent electrically insulating layer structure, it may be possible that the lateral wall of said at least one electrically conductive element results with an irregular shape. The irregular shape may increase the overall surface area of the at least one electrically conductive element and thus may ensure reliable adhesion between the at least one electrically conductive element and the adjacent electrically insulating layer structure.

According to a further embodiment of the present invention, said conductive paste comprises metal particles, said at least one electrically conductive element laterally extending following said metal particles. In an example, the size of the metal particles may be in the range between 500 nm to 30 µm, in particular in the range between 400 nm to 25 µm. In another example, the metal particles may comprise a polymodal or monomodal size distribution. This may bring the advantage, that the metal particles increase the adhesion between the at least one electrically conductive element and the electrically insulating layer structure, since the metal particles increase the total surface area of the at least one electrically conductive element significantly. This is known that particles having a size in the micro meter- and/or nano meter- range have a surface area of several square meters, in particular several hundred square meters, per gram of material.

According to another embodiment of the present inventions, the valleys extend toward the conductive paste defining undercuts hidden by external metal portions of the paste. The irregular shaping of the conductive paste, in particular due to the influence of shear forces, may form the respective valleys. Thus the valleys may have different forms and/or shapes respective to each other. The valleys may increase the surface area of the at least one electrically conductive element in the micro meter range.

According to a further embodiment of the present invention, said at least one electrically insulating layer structure at least partially fills the irregular profile, in particular filling the valleys. Thus the valleys may act as an anchor like structure enhancing the mechanical interaction of the electrically insulating layer structure and the at least one electrically conductive element resulting in a reliable interconnection between two adjacent electrically conductive layer structures.

According to a preferred embodiment of the present invention, said at least one electrically insulating layer structure comprises fillers. In an example, the fillers may comprise organic and/or inorganic material, for example comprising silicon oxide or aluminium oxide. In another example, the fillers may comprise particles, for example having spherical shape, or fibers having an elongated shape. The fillers may change the physical and/or mechanical properties of the electrically insulating layer structure and thus may enhance the physical properties of the stack, for example the stiffness.

According to a preferred embodiment of the present invention, a plurality of said fillers are provided at the irregular profile of the at least one electrically conductive element, in particular at least partially within the valleys defined by said profile. The fillers may impart mechanical properties to the at least one electrically conductive element and thus may for example strengthen the stability of the at least one electrically conductive element. This may result in an overall more stable component carrier.

According to another embodiment of the present invention, the lateral extension of the at least one electrically conductive element is affected by said fillers, in particular disrupting said lateral extension at the portion where the fillers are exposed from the insulating material. In an example at least one filler may protrude radially into the at least one electrically conductive element thereby disrupting the lateral extension of the at least one electrically conductive element. Since a plurality of fillers may disrupt the at least one electrically conductive element, the physical and/or mechanical properties of the at least one electrically conductive element may be influenced by the physical and/or mechanical properties of the fillers and thus may enhance the overall physical and/or mechanical property of the at least one electrically conductive element.

According to a further embodiment of the present invention, said fillers comprise fibers and/or particles. By variation of the shape of the fillers the physical and/or mechanical properties of the electrically insulating layer structure may be tuned.

According to a preferred embodiment of the present invention, said fillers comprise fibers, said fibers in particular being configured as forming a reinforcing cloth embedded in the at least one electrically insulating layer structure, wherein said fibers protrude toward the paste disrupting the lateral extension of the at least one electrically conductive element. Weaving of fibers forms a cloth. Said woven fibers or cloth have improved overall physical properties compared to respective fibers, example tensile strength. These improved physical properties may be imparted to the at least one electrically conductive element when said fibers protrude toward the paste disrupting the lateral extension of the at least one electrically conductive element resulting in an integral component carrier. Additionally or alternatively, the fibers may be integrated in the at least one electrically conductive element. This may enhance the mechanical stability of the at least one electrically conductive element since the electrically conductive paste may at least partially embrace said fibers resulting in a fixation by locking.

According to another embodiment of the present invention, the at least one electrically insulating layer structure comprises resin, a portion of resin in contact with said fibers protrudes toward the electrically conductive paste. The portion of resin, which protrudes towards the conductive paste, in particular into the valleys associated to the at least one electrically conductive element, may mechanically interlink in the anchor-like valleys and thus ensured a reliable mechanical integration of the at least one electrically conductive element in the electrically insulating layer structure.

According to a preferred embodiment of the present invention, the fillers comprise inorganic material, in particular silicon and/or bromine. Said element may impart dedicated properties to the electrically insulating layer structure, for example flame retardancy and/or a CTE value smaller than 20 ppm/K. In an example, the fillers may comprise electrically insulating material. Thus this component carrier may be less prone to warpage issues and/or may decrease the evolution of fire when burning.

According to a further embodiment of the present invention, in the center region of the conductive paste only resin without fillers is provided. This may be the footprint that the material of the adjacent electrically insulating layer structure is not entered up to the center region of the at least one electrically conductive element even considering the irregular shape of the latter, bringing the advantage that in the center region the electrical conductivity is higher compared to a region on the contour of the conductive paste, since the amount of electrically conductive material is higher due to the lack of fillers, which have electrically insulating properties.

In context of the present invention the term "center region" may refer to a region of the at least one electrically conductive element, which is distanced to the circumference and/or boundary region of the body of the at least one electrically conductive element. The center region may be at least distanced from the outer contour of the related body of at least 5 µm, in particular at least 10 µm. Contrarily, the term "boundary region" may refer to a region of the at least one electrically conductive element, which is in close proximity to the outer contour of the at least one electrically conductive element. In an example, the boundary region may relate to the outermost portion of the at least one electrically conductive element and may have a thickness smaller than 10 µm, in particular smaller than 5 µm. Thereby the composition of the material in the center region may be different to the composition of the material of the region associated to the outer contour of the same object or geometrical body.

According to another embodiment of the present invention, the conductive paste comprises at least two metals, in particular two among copper, silver, gold, tin, bismuth. Since an electrically conductive connection between the at least one electrically conductive element and an adjacent electrically conductive layer structure shall be established, the use of said elements may be preferred, since for example copper and/or gold and/or silver may enhance the electrically conductivity of the electrically conductive paste, whereas tin and/or bismuth may enhance the mechanical connection between the at least one electrically conductive element and the adjacent electrically conductive layer structure due to the solder and/or sinter behavior and/or properties.

According to a further embodiment of the present invention, the ratio between the two metals in the central region is different from the ratio at the respective boundary region of the at least one electrically conductive element. This may result due to the applied shear forces during manufacturing. In an example, during pressing the applied temperatures may partially melt one of the metal, for example tin or bismuth. Said melted metal may have different behavior and/or reaction on applied shear forces compared to another metal, for example copper or gold, which does not melt. This different reaction on applied shear forces may result in a different ratio (of the composition) of the two metals when comparing the boundary region with the central region.

According to a preferred embodiment of the present invention, the amount of the first metal, in particular copper, in the central region of the at least one electrically conductive element is higher, in particular 20% more, than the amount of the second metal, in particular tin, in the respective central region.

According to another embodiment of the present invention, the amount of the second metal, in particular tin, in the boundary region of the at least one electrically conductive element is higher, in particular 20% more, than the amount of the first metal, in particular copper, in the respective boundary region. Due to complex flow behaviour, in particular caused by inertia, the second material, may be transported more efficiently to the boundary region resulting in different composition of the material, in particular metal, when comparing the center region with the boundary region of the at least one electrically conductive element.

According to a further embodiment of the present invention, the amount of the second metal in the boundary region in contact with the at least one electrically insulating layer structure, in particular with the respective filler, is higher than the respective amount of the first metal in contact with said at least one electrically insulating layer. This may bring the advantage that the adhesion of the electrically insulating layer structure may be enhanced to the second metal in the boundary region compared with the first metal in the boundary region, since the chemical affinity of the involved elements, in particular bromine to tin, is higher compared to the chemical affinity of the first metal to the material of the electrically insulating layer structure, in particular bromine to copper.

According to a preferred embodiment of the present invention, the majority of the metal in contact with the exposing fibers is the second metal. This may bring the advantage of integrating the fibers into the second metal, since during pressing the second metal melts. When the temperature is reduced after pressing, the second metal may solidify by at least partially integrating the fibers resulting is a strong mechanical connection between the second metal and the fibers.

According to a further embodiment of the present invention, the (electrically) conductive paste comprises at least one organic material. The organic material may act as a matrix material configured for hosting the electrically conductive particles. In an example, the organic material may comprise an organic polymer, in particular an epoxy resin. In another example, the mass ratio of the organic material may be smaller than 20 weight percent, in particular smaller than 10 weight percent. The organic material may stick the electrically conductive particles together, which simplifies the application of the electrically conductive paste material during manufacturing.

According to another embodiment of the present invention, the boundary region of the at least one electrically conductive element comprises the metal of the paste, the organic material of the paste and the material of the at least one electrically insulating layer structure. This may bring the advantage of interconnecting the materials of the electrically conductive element with the electrically insulating layer structure in a mechanical manner, for example by fixation by locking. Additonally or alternatively, different physical attractive forces may act between the material of the at least one electrically conductive element and the electrically insulating layer structure. This may result in a composite structure ensuring good integrity of the stack, which is less prone to delamination events.

According to a preferred embodiment of the present invention, a plurality of electrically conductive elements passing through said at least one electrically insulating layer structure, each of said plurality of electrically conductive elements comprising an electrically conductive paste provided in a respective cavity being located at least partially within the at least one electrically insulating layer structure, wherein the center of gravity of one vertical extremity of the electrically conductive elements is misaligned with respect to the respective center of gravity of the opposed other extremity of said electrically conductive elements. This may bring the advantage of manufacturing component carriers may complex designs in an efficient and easy way using the described method.

According to another embodiment of the present invention, the amount of the fillers, in particular the amount of the fibers, exposed in the cavity of one electrically conductive element is different from the respective amount exposed in the cavity of a further electrically conductive element. This may result from manufacturing the component carrier using the described method, since during pressing the occurring local shear forces on the respective electrically conductive element and the further electrically conductive element are locally different and/or since the planar distribution of the plurality of electrically conductive elements is different from the planar distribution of the fillers. For example, the the planar distribution of the plurality of electrically conductive elements may be a pattern with specific distances among the adjacent electrically conductive elements, whereas the fillers may be a woven of fibers defining a plurality of beams distanced one to each other of further (different) distances. Nevertheless, each of the electrically conductive element and the further electrically conductive element may be reliably integrated in the stack and having an electrically conductivity configured for sufficiently transmitting electrical signals and/or current.

According to a further embodiment of the present invention, at least two, in particular the majority, of the plurality of electrically conductive elements have shapes different one to each other. Depending on the distribution of the fillers, in particular the fibers, in addition to the local position of the respective electrically conductive elements, the shapes of the respective electrically conductive elements may be different. Nevertheless, the average extension, for example in radial and/or axial direction, of the different electrically conductive elements may vary with a deviation of smaller than 20%, in particular smaller than 10% without interfering the mechanical and/or electrical performance of the respective electrical conductive element.

According to a preferred embodiment of the present invention, the misalignment of the gravity center of the opposed vertical extremities of each electrically conductive element of said plurality of electrically conductive elements are misaligned of the same value of and/or toward the same direction within a tolerance of 5%-20% of the misalignment value and/or angle. This may be due to the different local shear forces acting on the respective electrically conductive elements by using the described method while planarly sliding the layers along one to each other. Nevertheless, a reliable mechanical and electrical connection between the two electrically conductive layer structures via the respective electrically conductive elements may be ensured.

According to another embodiment of the present invention, the area extension of the vertical extremities at the same side of the at least one electrically insulating layer structure of the plurality of electrically conductive elements are the same within a tolerance of 5%-20% of the average area value. This is the footprint of the slided layer structures, equally or similarly affecting the plurality of electrically conductive elements, bringing the advantage that each of the electrically conductive elements may have similar connection to the adjacent electrically conductive layer structures and thus may ensure a reliable integration of the plurality of electrically conductive elements into the stack of the component carrier.

According to another embodiment of the present invention, the method of manufacturing the component carrier comprises the steps of laminating, in particular applying pressure and more in particular also temperature on the stack, allowing the layers to be pressed and to planarly slide along one to each other during the lamination. This may bring the advantage lowing the viscosity of the at least one electrically conductive element and/or the electrically insulating layer structure and thus enable an easier compensation of applied shear forces by deforming the at least one electrically conductive element. The lowered viscosity may be a result of applying elevated temperature. The lowered viscosity may enable the at least one electrically conductive element to deform into a position having low internal mechanical tension in an easy and sufficient way.

The preferred embodiments presented with reference to a component carrier according to the first aspect of the present invention and its advantages apply correspondingly to a method according to the second aspect of the present invention.

Further features of the invention are shown in the claims, the figures and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### SHORT DESCRIPTION OF THE DRAWINGS

The aspects of the present invention defined above, and further aspects of the invention are apparent from the examples, will now be explained in more detail by way of preferred examples and with reference to the accompanying, but not limiting, drawings.

The accompanying drawings merely present some embodiments of the present invention. Modifications to these embodiments are possible without departing from the scope of the present invention as defined in the claims. Functionally identical components are provided with the same reference signs for ease of understanding, in particular for simplified recognition, even if they are or may be designed differently, whereby differences may lie in particular in the dimensions, geometry and/or shape as well as in the material and/or their location within the component carrier.

The drawings show:
- **Fig. 1:**: a component carrier as known from prior art,
- **Fig. 2:**: a cross-section through a component carrier as known from prior art in the area of an electrically conductive element which lacks reliability of the electrical connection due to an insufficient electrical connection in at least one contact region caused by an insufficient amount of conductive paste, as a result of which no sufficient compression of the paste and no sufficient deformation of the paste can be achieved and therefore no sufficient electrical contacting,
- **Fig. 3a:**: a first embodiment of a component carrier according to the first aspect of the present invention,
- **Fig. 3b:**: a three dimensional schematic illustration of an exemplary shape of the electrically conductive element of a component carrier according to the present invention
- **Fig. 4:**: a schematic illustration of a first embodiment of a manufacturing process according to the second aspect of the present invention for manufacturing of a first embodiment of a component carrier according to the present invention,
- **Fig. 5a:**: a schematic illustration of a second embodiment of a manufacturing process according to the second aspect of the present invention for manufacturing of a preferred embodiment of a component carrier according to the present invention, and
- **Fig. 5b:**: a schematic illustration of the resulting component carrier manufactured according to Fig. 5a.
- **Fig. 6:**: a second embodiment of a component carrier according to the first aspect of the present invention,
- **Fig. 7:**: a third embodiment of a component carrier according to the first aspect of the present invention,
- **Fig. 8:**: a fourth embodiment of a component carrier according to the first aspect of the present invention,
- **Fig. 9a:**: a schematic illustration of an exemplary shape of the electrically conductive element of a component carrier according to the present invention,
- **Fig. 9b:**: a schematic illustration of an exemplary shape of the electrically conductive element of a component carrier according to the present invention,
- **Fig. 9c:**: a three dimensional schematic illustration of an exemplary shape of the electrically conductive element of a component carrier according to the present invention,
- **Fig. 10a:**: a further schematic illustration of an exemplary shape of the electrically conductive element of a component carrier according to the present invention,
- **Fig. 10b:**: a further schematic illustration of an exemplary shape of the electrically conductive element of a component carrier according to the present invention in top view,
- **Fig. 10c:**: a further three dimensional schematic illustration of an exemplary shape of the electrically conductive element of a component carrier according to the present invention,
- **Fig. 11a** to **11c:**: further schematic illustrations of different examples of possible shapes of the electrically conductive element of a component carrier according to the present invention,
- **Fig. 12:**: a cross-section through an embodiment of a component carrier according to the present invention in the area of an electrically conductive element with a first possible configuration of the electrically conductive element (similar to that one schematically illustrated in Fig. 3),
- **Fig. 13:**: a schematic illustration of an example of a core area of the electrically conductive element in which the particles concentration of the conductive particles of the conductive paste may be higher,
- **Fig. 14:**: a cross-section through a further embodiment of a component carrier according to the present invention in the area of an electrically conductive element with a further possible configuration of the electrically conductive element, wherein the configuration of the conductive element corresponds to Fig. 8,
- **Fig. 15:**: a cross-section through a further embodiment of a component carrier according to the present invention in the area of an electrically conductive element with a further possible configuration of the electrically conductive element,
- **Fig. 16** to **26:**: cross-sections through different embodiments of component carriers according to the present invention in an area of an electrically conductive element with further possible configurations of the electrically conductive element,
- **Fig. 27:**: a scanning electron micrograph of a section through an embodiment of a component carrier in a transition region of the electrically conductive element and the electronically insulating layer structure, wherein the electrically insulating layer structure comprises glass fibers,
- **Fig. 28** to **33:**: further cross-sections through further different embodiments of component carriers according to the present invention in an area of an electrically conductive element with further possible configurations of the electrically conductive element,
- **Fig. 34:**: a scanning electron micrograph of a section through an embodiment of a component carrier in a transition region of the electrically conductive element and the electronically insulating layer structure,
- **Fig. 35:**: an enlarged view of Fig. 27,
- **Fig. 36:**: a scanning electron micrograph of a section through an embodiment of a component carrier in a center region of the electrically conductive element,
- **Fig. 37:**: a scanning electron micrograph coupled to an energy dispersive X-ray spectrometer of a section through an embodiment of a component carrier in a transition region as shown in Fig. 35 of the electrically conductive element and the electronically insulating layer structure, wherein the electrically insulating layer structure comprises glass fibers, and
- **Fig. 38:**: a scanning electron micrograph coupled to an energy dispersive X-ray spectrometer of a section through an embodiment of a component carrier in a center region as shown in Fig. 36 of the electrically conductive element.

### DETAILED DESCRIPTION

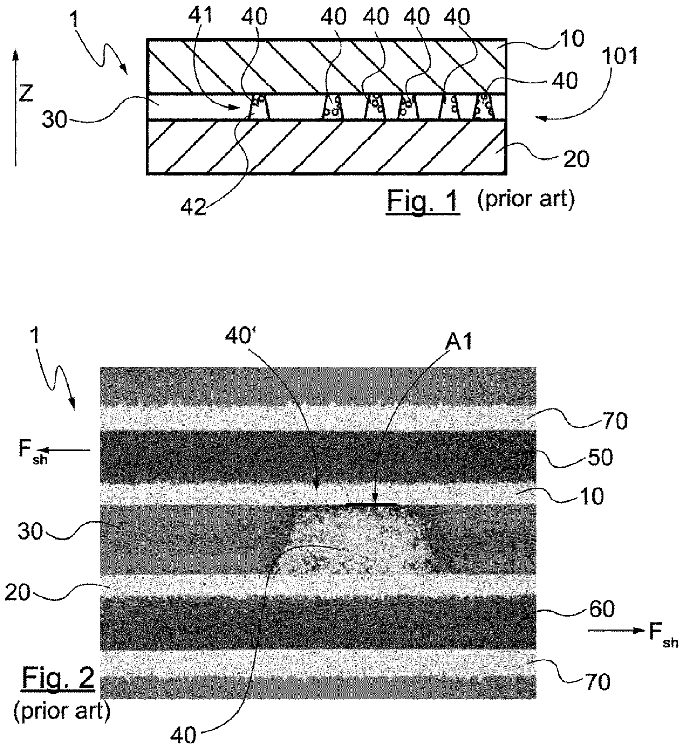

**Fig. 1** shows a component carrier 1 as known from prior art, wherein this component carrier 1 comprises a stack 101 in this example having two electrically conductive layer structures 10 and 20 which are stacked one above each other in thickness direction and/or stacking direction Z with an electrically insulating layer structure 30 in between. The electrically conductive layer structures 10 and 20 are connected via electrically conductive elements 40, so-called "vias" 40, each being formed by an electrically conductive paste 42 being provided in cavities 41, wherein in this example the cavities 41 are completely filled with the electrically conductive paste 42. All cavities 41 have a symmetrical, frustoconical shape and have been created by laser drilling, wherein the material removal has taken place in direction from the bottom electrically conductive layer structure 20 towards the upper electrically conductive layer structure 10.

**Fig. 2** shows a cross-section through a component carrier 1 as known from prior art in the area of an electrically conductive element 40. This component carrier 1 is in principle buildup similarly to the component carrier as illustrated in Fig. 1. In contrast to the component carrier 1 illustrated in Fig. 1, this component carrier additionally comprises a few more layer structures 50 and 70 at the upper side and as well 60 and 70 at the bottom side, wherein the layer structures 50 and 60 are electrically insulating carrier structures and the layer structures 70 are further layer structures 70, in particular also electrically conductive layer structures for electrical connection of the component carrier one with component or other parts outside of the component carrier 1.

As can be clearly seen in Fig. 2, the component carrier 1 lacks reliability of the electrical connection (see 40') in a first contact area A1 due to an insufficient electrical connection 40' in the contact region A1. The insufficient electrical connection 40' is in this case caused by an insufficient amount of conductive paste 42 filled into the cavity 41, wherein the amount of the conductive paste 42 was not well-adapted to the cavity design. This led to an insufficient compression of the paste 42 during manufacturing of the component carrier 1 and no sufficient deformation of the paste 42 and no sufficient adaptation of the shape of the conductive element 40 was achieved. Thereby, no sufficient electrical contacting was established by the electrically conductive element 40 formed of the paste 42.

As can be clearly seen in Fig. 2, the electrically conductive element 40 fails to completely electrically connect the upper electrically conductive layer structure 10 over its complete extension perpendicular to stacking direction Z.

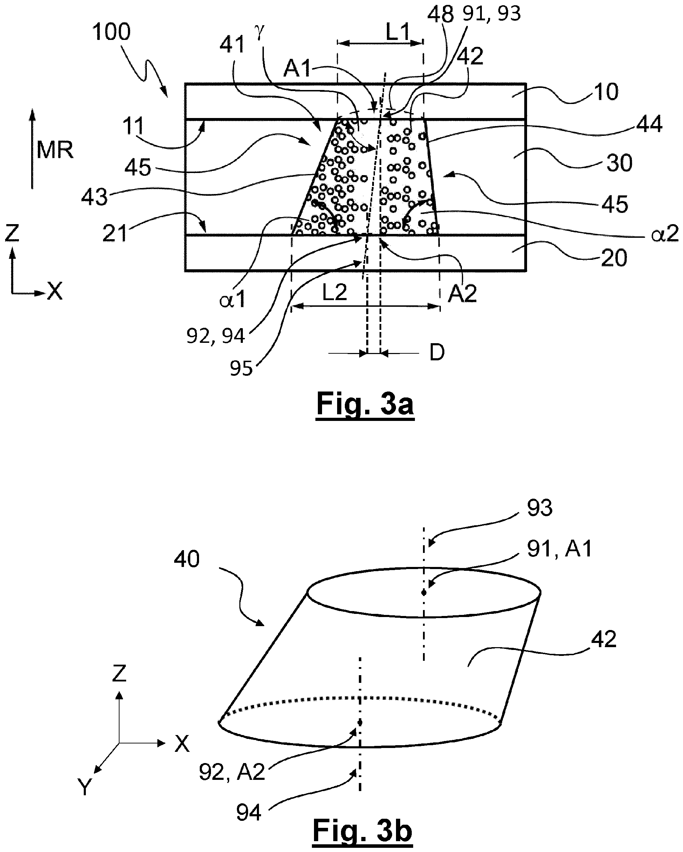

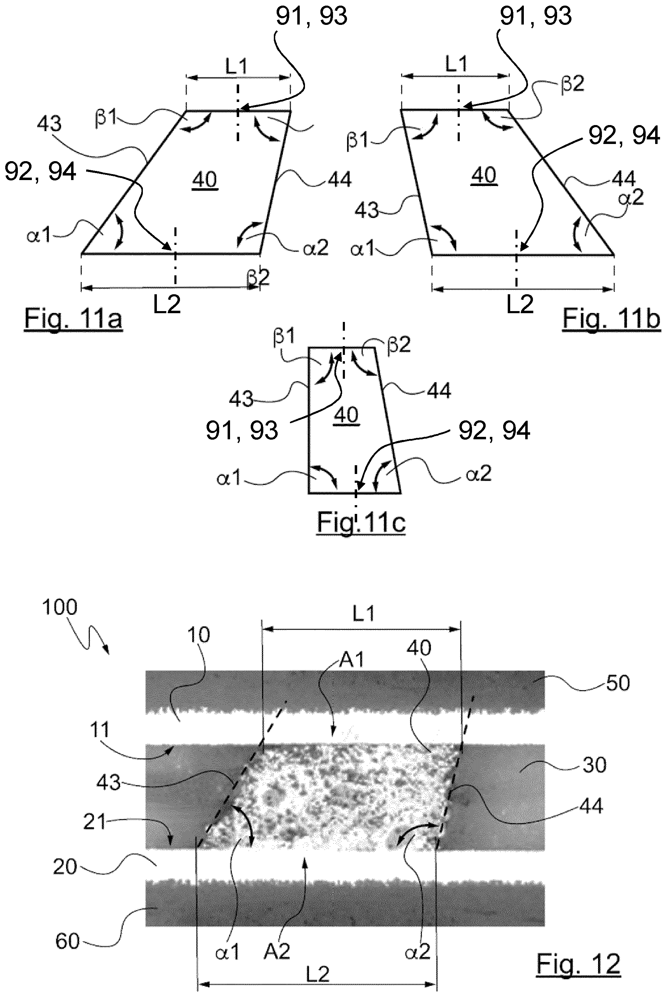

As a result, the electrical contact is only established in a small contact area A1 and therewith insufficient. Only in the area A1 an upper part of the electrically conductive element 40 is electrically connected with the electrically conductive layer structure 10. The result is an electrical connection not fulfilling the requirements, for example having a higher electrical conductivity, for example at least 2 times higher, in particular 10 times higher, compared to electrically conductive elements 40 fulfilling the requirements for example as shown in Fig. 3a or Fig. 12.

This failure pattern may in particular occur, if the electrically conductive layer structures 10 and 20 are electrically connected one to each other by small vias 40, in particular by vias 40 having small diameters (i.e. diameters in a range from 15 µm to 500 µm, in particular of less than 0.3 mm) and/or if the electrically insulating layer structure 30 has a dielectric constant Dk >1.5, 1.7, 2.0 or 4.0 (e.g. a high dielectric constant of Dk >4.0) and/or if a shrinkage or a shearing force Fₛₕ of the outer layer structures 50, 60, 70 exceeds a threshold which may be tolerated from the electrically conductive element 40.

**Fig. 3a** shows an example of a component carrier 100 according to the first aspect of the present invention which has a reduced risk of occurrence of the above-described connections/conduction failures. It has been found by the inventors of the present invention that with a specific design of the electrically conductive element 40, respectively with a specific design and/or manufacturing of the cavity 41 into which the electrically conductive paste 42 is later brought in, in particular with a proper amount, the risk of the occurrence of this defect or failure pattern can significantly be reduced. It was in particular found, that the risk of failure could significantly be reduced when the cavity 41 is completely filled with the paste 42, in particular overfilled. Advantageous seems to be filling the cavity 41 with an amount of conductive paste having a volume (Vol-%) of at least 100%, 110%, 120%, 130%, 140% or 150%, but preferably less the 160%, 170%, 180% 190% or 200% of the original cavity volume.

This example of a component carrier 100 according to the present invention comprises a stack 101 with in this illustration only two electrically conductive layer structures 10 and 20, which are stacked one above the other in stacking direction respectively thickness direction Z with an electrically insulating layer structure 30 in between. In an example, at least one of said two electrically conductive layer structures 10, 20 is provided on one of the main surfaces of the at least one electrically insulating layer structure 30. Additionally or alternatively, at least one of said two electrically conductive layer structures is provided on one of the main surfaces of one further electrically conductive layer structure. In a preferred example, the one of said two electrically conductive layer structures 10, 20, more preferably both, may be at least partially embedded in the at least one electrically insulating layer structure 30, in particular exposing at one of the main surfaces of said at least one electrically insulating layer structure 30. The electrically conductive layer structures 10 and 20 are mechanically and/or electrically connected one to each other by the electrically conductive element 40, which is formed by an electrically conductive paste 42 which is provided in cavity 41. The cavity 41 is located completely within the electrically insulating layer structure 30 and is extending in thickness direction Z between the two electrically conductive layer structures 10 and 20. In a preferred example, the electrically conductive paste 42 may be sandwiched between the at two electrically conductive layer structures 10, 20.

The cavity 41 is in lateral direction X delimited by a lateral wall 45 of the electrically insulating layer structure 30, wherein the lateral wall 45 is formed by the inner wall of the hole or recess forming the cavity 41 extends completely in a circumferential direction around the electrically conductive paste 42. The lateral wall 45 has two opposed portions 43 and 44, which have according to one exemplary embodiment different inclinations α1 and α2 relative to a contacting plane 21 and between the electrically conductive layer structure 20 and the electrically insulating layer structure 30 with respect to thickness direction Z of the stack 101.

Lateral wall 45, in particular at least the opposed portions 43 and 44, have a specific shape, in this example in particular a straight shape, i.e. they are at least partially, in particular over their complete length in thickness direction Z, straight or linear.

Contrary to the illustration in Fig. 3a, the shape of the lateral wall 45 has not mandatorily to be constant in thickness direction Z, rather it may vary in other embodiments.

The lateral wall may have in particular different portions with different shapes in thickness direction and/or as well in circumferential direction. One or more portions may for example have a straight shape and/or one or more portions may have an irregular shape or a curved shape, in particular a convex or concave shape and/or combinations thereof.

The electrically conductive element 40, in particular the electrically conductive paste 42, is in (electrical) contact with electrically conductive layer structure 10 in a first contact area A1 at the contacting plane 11, and also with the electrically conductive layer structure 20 in the second contact area A2 at its contacting plane 21. The two contact areas A1 and A2 are located opposed to each other, in particular at opposed extremities of the electrically conductive element 40, in thickness direction Z. As it is apparent from Fig. 3a, in this example the first contact area A1 is located at the upper side of the electrically conductive element 40 and the second contact area A2 is located at the bottom side of the electrically conductive element 40.

In the example illustrated in Fig. 3a, the first contact area A1 and the second contact area A2 are extending along a planar respective extension, in particular in a first direction which in this example corresponds to lateral direction X, wherein an extension of the first contact area A1 (here its length L1) is smaller than an extension (here length L2) of the second contact area A2. In particular, the first contact area A1 and the second contact area A2 have respective average diameters, which are different. Alternatively, the extension of the first contact area A1 (here its length L1) may be similar, in particular the same, as the extension of the second contact area A2 (here its length L2), or the extension of the first contact area A1 (here its length L1) may be larger than the extension (here length L2) of the second contact area A2.

The electrically conductive element 40 is, as already mentioned above, formed from an electrically conductive paste 42 with which the cavity 41 in the electrically insulating layer structure 30 has been filled, wherein in this example cavity 41 is filled completely. Additionally or alternatively, at least a part of the electrically conductive element 40, may at least partially be filled with other material compared to the electrically conductive paste 42, for example with resin being free from electrically conductive particles and/or gas.

Preferably, the conductive paste 42 is free of cadmium (Cd) and lead (Pb) and comprises electrically conductive particles (not indicated herein with reference sign).

In the embodiments shown in the present application, a plurality of the electrically conductive particles comprises metal particles 42a, in particular particles made of copper (Cu). Additionally or alternatively, the electrically conductive paste 42 may comprise particles comprising Sn and/or Ag and/or Bi. In an embodiment, the electrically conductive particles may comprise a particle size smaller than 80 µm, in particular in the range between 500 nm and 30 µm. Preferably the electrically conductive particles may have a round shape, for example a spherical shape or an elliptical shape, and/or the electrically conductive particles may have a polymodal size distribution. Alternatively, the electrically conductive particles may have a monomodal size distribution or a size being in the range between 50 nm and 500 µm. In an example, the electrically conductive paste may comprise an electrically conductive particle loading larger than 65 w%, in particular larger than 80 w%.

The cavity 41 has preferably (before it has been filled by the conductive paste 42) been created by material removal in material in a material removal direction MR by using laser means. As symbolically indicated by the dotted line in Fig. 3a, in the contact area A1 the contacting plane 11 formed by the bottom main surface of the electrically conductive layer structure 10 is preferably not ideally planar, but rather comprises a slight dimple 48 which is facing towards the cavity 41 with its opening. Thereby, the connection strength with the electrically conductive layer structure 10 can be increased and connection quality can be improved.

A (vertical) extremity of the electrically conductive element 40 associated to the first contact area A1 comprises a first center of gravity 91. Said first center of gravity 91 is preferably located inside the external boundary profile of the at least one electrically conductive element 40 when considering a plane perpendicular to the stacking direction Z. A first (vertical) axis 93 having a direction parallel to the stacking direction Z is located such, that it is passing through the first center of gravity 91 (of the electrically conductive element 40). Furthermore, the opposed (other vertical) extremity of the electrically conductive element 40 associated to the second contact area A2 comprises a second center of gravity 92. Said second center of gravity 92 is preferably located inside the external boundary profile of the at least one electrically conductive element 40 when considering a plane perpendicular to the stacking direction Z. A second (vertical) axis 94 having a direction parallel to the stacking direction Z is located such, that it is passing through the second center of gravity 92 (of the electrically conductive element 40). As shown in Fig. 3a a further (virtual) axis 95 passes through the center of gravity of each one 91, 92 of the two vertical extremities of the at least one electrically conductive element 40. Said axis may be inclined having an inclination angle γ with respect to one main surface 21 of the electrically conductive layer structure 20 and/or, the electrically insulating layer structure 30 with respect to thickness direction Z of the stack 101, more in particular one of the stack main surfaces. According to the invention, the first center of gravity 91 and the second center of gravity 92 are misaligned with respect to each other. Preferably, the first center of gravity 91 and the second center of gravity 92 are misaligned with respect to each other from a planar view of the stack 101, in particular from a planar view being perpendicular to stacking direction Z. The misalignment of the first center of gravity 91 and the second center of gravity 92 of the electrically conductive element 40 may have a planar offset D, in particular a distance. The planar offset D may be the distance of the orthogonal projection of the distance of the first center of gravity 91 and the second center of gravity 92 when projecting to a plane perpendicular to the stacking direction Z. The planar offset D may be defined as the distance, from a planar point of view, between the first center of gravity 91 and the second center of gravity 92. According to an exemplary embodiment, the planar offset D may be smaller than 100 µm, in particular smaller than 80 µm. According to a further exemplary embodiment, the planar offset D may be larger than 1 µm, in particular in the range between 5 µm and 70 µm. Preferably, the misalignment value between the first center of gravity 91 of one vertical extremity of and the second center of gravity 92 of the opposed other vertical extremity of the at least one electrically conductive element 40 may be of a value resulting in a ratio between 5% to 60% with respect to the lateral extension, for example the average diameter, of said at least one electrically conductive element 40. This misalignment value between the first center of gravity 91 of one vertical extremity of and the second center of gravity 92 of the opposed other vertical extremity of the at least one electrically conductive element 40 may be of a value resulting in a ratio between 1% to 100% with respect to the lateral extension, for example the average diameter, of said at least one electrically conductive element 40. The inclination y may be different than 90°, in particular within the range of 50° and 89° with respect to one of the stack main surfaces. Alternatively, inclination y may be bigger than 30° but smaller than 90°. The planar offset D and/or the inclination y may be a result of the applied method, in particular by overfilling the cavity 41 with material of the electrically conductive paste 42 and further applying elevated temperatures, for example higher than 80 °C, in particular higher than 100 °C, and/or elevated pressure, for example higher than 2 bars, in particular higher than 5 bars. Additionally or alternatively, the planar offset D and/or the inclination y may be a result a planarly slipping perpendicular to the stacking direction Z of the different layer structures, in particular the at least two electrically conductive layer structures 10, 20 and the at least one electrically insulating layer structure 30, which are associated to the electrically conductive element 40. The planarly slipping may be the consequence of a (slightly) freedom of the layers used for the stack formation to planarly slide one to each other, actually moving during the hot-pressing by internal and/or partial shear forces Fₛₕ occurring during the method applied for manufacturing the related component carrier 100. The consequence of said allowed planar slipping is that the electrically conductive element 40 may have a low internal stress and/or low internal tension and/or good mechanical connection and/or high electrically conductivity due to the freedom of adaptation of the electrically conductive paste 42 during the hot-pressing and/or lamination, also moving the layer structures during this process, creating a reliable interconnection between the at least two adjacent electrically conductive layer structures 10, 20.

**Fig. 3b** shows a schematic example of an electrically conductive element 40 in three dimensional view similar to Fig. 3a. The electrically conductive element 40 has a vertical extremity associated to a first contact area A1. Said first contact area A1 may have a planar surface area. Alternatively, the first contact area A1 may have a three dimensional surface area caused by the dimple 48. In a cross sectional view being perpendicular to the stacking direction Z the first contacting area A1 may have a regular shape, for example a circular shape, an elliptical shape or a square like shape. Alternatively, the first contacting area A1 may have an irregular shape in a cross sectional view being perpendicular to the stacking direction Z. The electrically conductive element 40 further comprises an opposed other vertical extremity associated to a second contact area A2. Said second contact area A2 may have a planar surface area. In a cross sectional view being perpendicular to the stacking direction Z the second contacting area A2 may have a regular shape, for example a circular shape, an elliptical shape or a square like shape. Alternatively, the second contacting area A2 may have an irregular shape in a cross sectional view being perpendicular to the stacking direction Z. The first contacting area A1 and the second contacting area A2 are connected with each other by a lateral surface. Said lateral surface of the electrically conductive element 40 may be different, in particular bigger, than the first contacting area A1 and/or the second contacting area A2. Alternatively, the lateral surface of the electrically conductive element 40 may be substantially the same as the first contacting area A1 and/or as the second contacting area A2. Accordingly, the first center of gravity 91 is located at the contacting area A1 and the second center of gravity 92 is located at the contacting area A2. Furthermore, as can be seen by Fig. 3b, the first (vertical) axis 93 and the second (vertical) axis 94 are arranged in a coplanar way indicating that the first center of gravity 91 and the second center of gravity 92 may be misaligned, in particular distanced with each other.

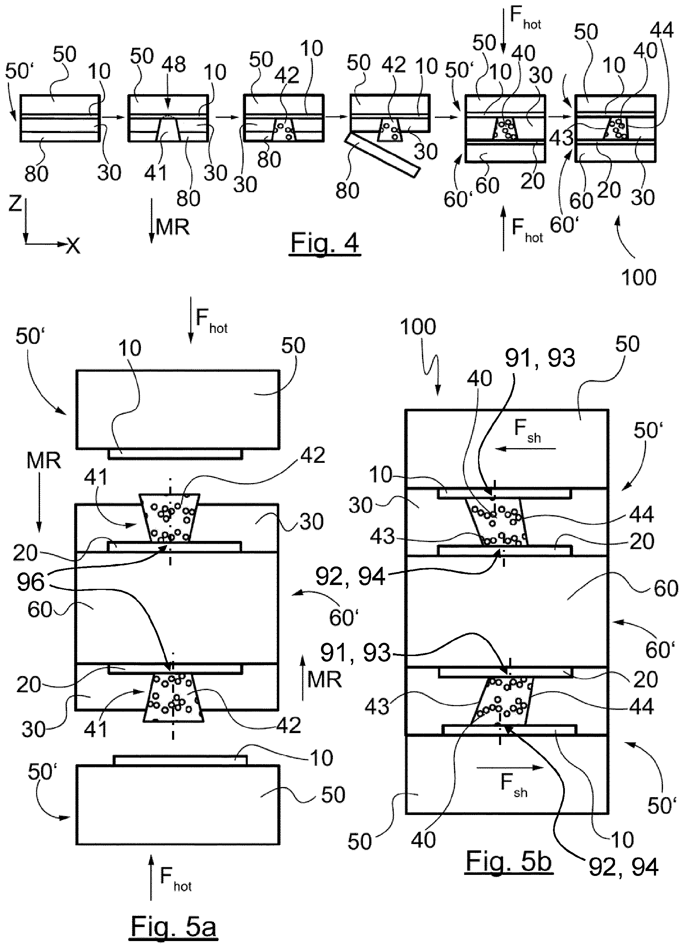

**Fig. 4** shows a schematic illustration of a preferred embodiment of a manufacturing process according to the second aspect of the present invention for manufacturing of a preferred embodiment of a component carrier 100 according to the present invention, wherein in a first step the electrically insulating layer structure 30 and the electrically conductive layer structure 10 are provided. In this example the electrically insulating layer structure 30 the electrically conductive layer structure 10 are part of a first sub-carrier 50' further comprising a carrier layer structure 50 (also being made of electrically insulating material) and a protective layer structure 80 applied onto the electrically insulating layer structure 30. The electrically conductive layer structure 10 is arranged at an outer main surface of the insulating layer structure 30.

In a next step, a cavity 41 is created, in particular by laser means, for example by laser drilling, preferably using a CO₂ laser or an UV laser. The cavity 41 is in particular created by material removal in a material removal direction MR from the outer surface of the electrically insulating layer 30 facing away from the electrically conductive layer structure 10 inwards and towards said electrically conductive layer structure 10, i.e. from the outer surface of the protective layer 80 inwards towards the electrically conductive layer structure 10.

Therein, the cavity 41 is created such that it preferably tapers towards the electrically conductive layer structure 10 and has a smaller extension in lateral direction at its inner side forming the bottom of the cavity 41 compared to its extension (in particular its diameter or a length in lateral direction) at its outer side.

In the next step, cavity 41 is filled with electrically conductive paste 42 before in a further step the optionally provided protective layer 80 is removed. In an alternative embodiment, the protective layer 80 may be removed first, before the cavity is filled with the electrically conductive paste 42.

In this example, the cavity 41 comprises also a slight dimple 48 at its bottom which contributes to the establishment of a high-quality electrical connection between the electrically conductive layer structure 10 and the electrically conductive paste 42 the cavity 41 is filled with.

In a further step, the second electrically conductive layer structure 20 is provided and stacked with the first sub-carrier 50' in order to form the stack and finally the component carrier 100. In this example, the second electrically insulating layer structure 20 is provided as part of a second sub-carrier 60', also further comprising a carrier structure layer 60 made of electrically insulating material.

The first sub-carrier 50' and the second sub-carrier 60' are preferably stacked one above each other in stacking direction Z such that the electrically insulating layer structure 30 is sandwiched in between the two electrically conductive layer structures 10 and 20 in order to enable the electrical connection of the electrically conductive layer structure 10 and 20 by the electrically conductive paste 42 the cavity 41 is filled with.

By applying pressure and preferably also heat, indicated by hot-pressing force Fₕₒₜ, in particular by hot-pressing, the several layer structures 10, 20 and 30 are laminated together and the electrical connection between the electrically conductive layer structures 10 and 20 is established via the electrically conductive paste 42, wherein the electrically conductive element 40 is formed. In this process step, at least some of the conductive particles of the electrically conductive paste 42, in particular in case of metal particles, may be welded and/or sintered together. Thereby, the strength of the electrical connection, in particular of the conductive element 40, can be increased.

The respectively resulting conductive element 40 is in lateral direction delimited by the electrically insulating layer structure 30, in particular by its lateral wall, wherein the lateral wall comprises at least two opposed portions with different inclinations (not indicated with reference sign in this figure for ease in favor of better clarity) as in detail described above with respect to a component carrier according to the first aspect of the present invention. During hot-pressing shear forces Fₛₕ and/or pressure may be applied on the electrically conductive element 40 and/or the electrically conductive layer structures 10,20 may planarly slide, in particular in different directions, resulting in a misalignment of the first center of gravity 91 and the second center of gravity 92. Said misalignment may reduce the internal stress of the electrically conductive element 42 and may ensure a reliable mechanical and/or electrical interconnection.

**Figs. 5a** shows a schematic illustration of a second embodiment of a manufacturing process according to the second aspect of the present invention for manufacturing of a preferred embodiment of a component carrier 100 according to the present invention, wherein in this example the component carrier 100 is made of three sub-carriers 50', 60' and 50', in particular of an inner sub-carrier 60' comprising a carrier layer 60, two electrically conductive layer structures 20 and two electrically insulating layer structures 30 arranged at the outer sides of the sub-carrier 60', and two outer sub-carriers 50', each comprising a carrier layer structure 50 and one electrically conductive layer structure 10.

As described above, also first the cavities 41 are created by material removal in material removal direction MR using laser means, wherein in the cavities 41 are then filled with an electrically conductive paste 42.

In a further step, the sub-carriers 50', 60' and 50' are stacked one above the other such that each of the electrically insulating layer structures 30 is sandwiched in between the respective two electrically conductive layer structures 10 and 20 in order to enable an electrical connection via the conductive paste 42 in between. Furthermore, as can be seen in Fig. 5a, another virtual axis 96 of the cavity 41 in the electrically insulating layer 30 is displayed. Thereby the other virtual axis 96 is parallel to stacking direction Z and passing through the top surface (area) and the bottom surface (area) of the electrically conductive paste 42.

Finally, in a hot-pressing step the sub-carriers 50', 60' and 50' are laminated together and the electrically conductive elements 40 are formed.

**Fig. 5b** shows a schematic illustration of the resulting component carrier 100 manufactured according to Fig. 5a. Both cavities 41 respectively both resulting conductive elements 40 are in lateral direction delimited by the surrounding electrically insulating layer structure 30, in particular by its lateral wall, wherein the lateral wall comprises at least two opposed portions 43, 44 with different inclinations as in detail described above with respect to a component carrier according to the first aspect of the present invention, but not indicated with reference sign in favor of better clarity.

It has been found by the inventors that creating at least one cavity 41 by material removal with a material removal direction MR from outwards to inwards with respect to the component carrier 100, in particular resulting in a cavity with the smaller extension of the contact area at the inner side of the cavity 41 and therewith at the inner side of the component carrier 100, may significantly reduce the risk of defects and/or failures of the connection element 40. In particular, the risk of shearing-off and/or slipping-off may significantly be reduced by creating the cavity 41 with material removal direction MR from outwards to inwards. The applied shear forces Fₛₕ created by applying pressure and more in particular also temperature on the stack 101, allowing the layers to be pressed and to planarly slide along one to each other during the lamination, may create the misalignment between the respective first center of gravity 91 and the second center of gravity 92 and/or between the respective vertical axis 93, 94. The misalignment between the respective first center of gravity 91 and the second center of gravity 92 may reduce the internal stress of the electrically conductive element 40 and thus ensures a reliable mechanical and/or electrical interconnection between the two adjacent electrically conductive layer structures 10, 20. Preferably, the first center of gravity 91 may be located such that it is closer to the inner sub-carrier 60' and the second center of gravity 92 may be located such, that is closer to the outer sub-carrier 50'. Alternatively, the first center of gravity 91 may be located such, that it is closer to the outer sub-carrier 50' and the second center of gravity 92 may be located such, that is closer to the inner sub-carrier 60'.

It may in particular be advantageous, if at least one cavity and/or at least one conductive element 40 comprises a tapered shape, in particular with the taper being orientated with its smaller diameter towards the center of the component carrier and which the larger diameter outwards.

Similar to the illustration in Fig. 1, in at least one embodiment of a component carrier according to the present invention, the component carrier may further comprise at least one further cavity 41 and/or at least one further electrically conductive element 40 formed by an electrically conductive paste 42 and as described above.

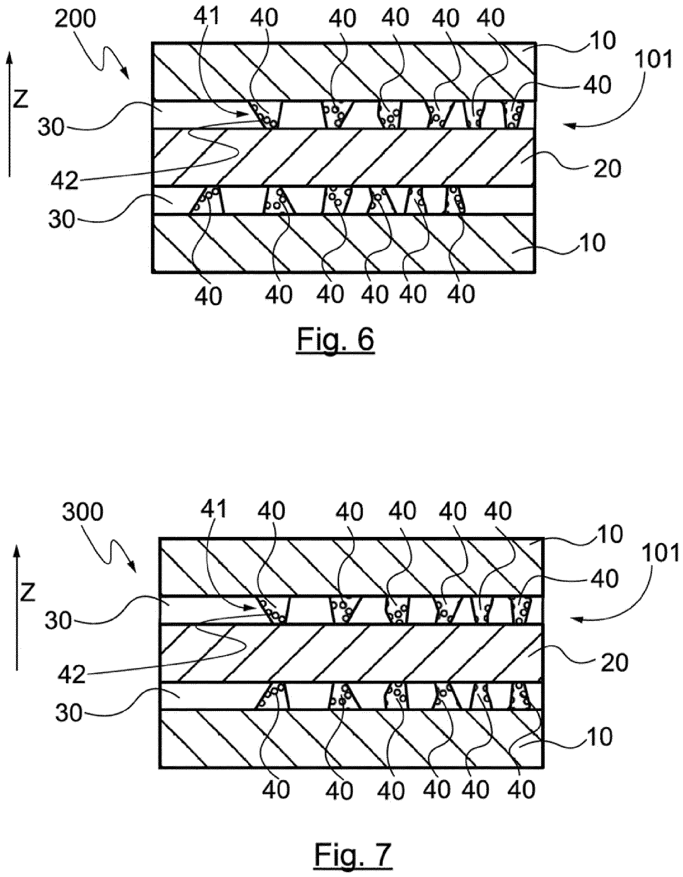

At least one further cavity 41 and/or electrically conductive element 40 may be located at least partially within the same electrically insulating layer structure 30 and also being arranged in stacking direction Z in between the two electrically conductive layer structures 10 and 20. At least one further cavity 41 and/or electrically conductive element 40 may also be at least partially delimited by a lateral wall 45 of the electrically insulating layer structure 30 in lateral direction X may also have at least two opposed portions 43 and 44 having different inclinations α1 and α2 or β1 and β2 relative to a contacting plane 11, 21. This is exemplarily shown in **Figs. 6** and **7****.**

**Fig. 6** shows a second embodiment of a component carrier 200 according to the first aspect of the present invention, and **Fig. 7** shows a third embodiment of a component carrier 300 according to the first aspect of the present invention, each comprising a plurality of cavities 41 and a plurality of conductive elements 40 located within the electrically conductive layer structure 30 and connecting two electrically conductive layer structures 10, 20 one to each other.

The conductive elements may be arranged aligned (in flush) one above the other in the several insulating layer structures 30, as exemplarily and schematically illustrated in Fig. 7. Alternatively, they may be arranged with a lateral offset or a lateral shift in a direction perpendicular to stacking direction, as exemplarily and schematically illustrated in Fig. 6. Also, a combination of these arrangement options is possible in a component carrier according to the present invention. In an embodiment according to the present invention, the first center of gravity 91 or the second center of gravity 92 and/or the respective axis 93, 94 of an electrically conductive element 40 are located such that it/they is/are misaligned with the first center of gravity 91 or the second center of gravity 92 and/or the respective axis 93, 94 of a further electrically conductive element 40 when the electrically conductive element 40 and the further electrically conductive element 40 are located in different respective electrically insulating layer structures 30 when considering a top view parallel to stacking direction Z. In an example, the misalignment of the second gravity center 92 of the opposed vertical extremities of each electrically conductive element of said plurality of electrically conductive elements are misaligned of the same value of and/or toward the same direction within a tolerance of 5% - 20% of the misalignment value and/or angle. In another example, the area extension of the vertical extremities at the same side of the at least one electrically insulating layer structure 30 of the plurality of electrically conductive elements 40 are the same within a tolerance of 5% - 20% of the average area value. Said misalignment may be created by the described manufacturing method where the layer structures, in particular the electrically conductive layer structures 10, 20, may planarly slide one to each other, then reducing and/or compensating internal forces inside the electrically conductive elements,even in case of a component carrier having electrically conductive element 40 located in different electrically insulating layer structures 30.

In addition or alternatively, at least one further cavity 41 or at least one further electrically conductive element 40 may be located in another insulating layer structure.

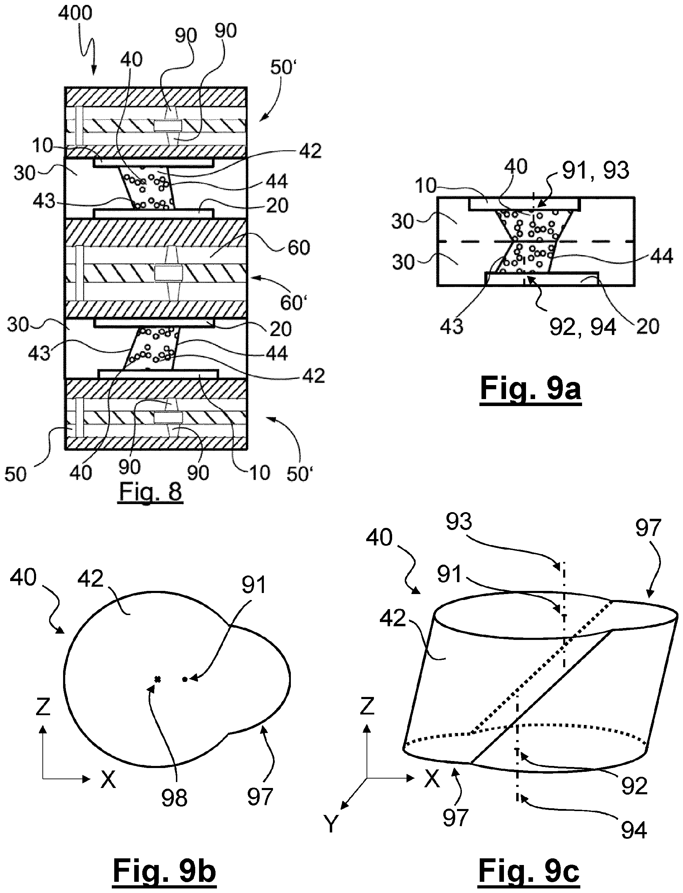

**Fig. 8** shows a fourth embodiment of a component carrier 400 according to the first aspect of the present invention, wherein this component carrier 400 is similar to the component carrier 100 described with respect to Figs. 4, 5a and 5b. However, this example of a component carrier 400 comprises multi-layer sub-carriers 50', 60', wherein in this example only the electrical interconnections between the sub-carriers 50', 60' are made with conductive elements 40 formed of conductive paste 42 according to the present invention. The other electrical interconnections within the several sub-carriers 50', 60' are in this example plated vias 90. Alternatively, one or more may also be established with conductive elements 40 formed of conductive paste 42 according to the present invention.

The conductive elements 40 of a component carrier according to the present invention may in particular comprise different shapes, sizes and volumes. This is symbolically shown in the different embodiments of component carriers 100 to 400 and the figures presented in this application. Several of the possible shapes and geometries are explained in more detail in the following.

**Fig. 9a** shows a schematic illustration of an exemplary shape of the electrically conductive element 40 of a component carrier according to the present invention, wherein in this embodiment the conductive element 40 has an "hour-glass" shape, in particular an asymmetric or irregular hour-glass shape.

Further, the electrically insulating layer structure is a double-layer structure, formed from two electrically insulating layer structures 30 stacked one above the other during manufacturing.

The upper insulating layer structure 30 may for example be mechanically connected to the upper electrically conductive layer structure 10 and stacked simultaneously with the lower electrically conductive layer structure 20 and the lower insulating layer structure 30.

And the lower electrically insulating layer structure 30 may for example be mechanically connected to the lower electrically conductive layer structure 20 and simultaneously stacked with the upper electrically conductive layer structure 10 and the upper electrically insulating layer structure 30.

The conductive element 40 may also be formed from two parts: of a first amount of paste 42 filled into a cavity in the upper insulating layer structure 30, and from a second amount of paste 42 filled into a cavity in the lower insulating layer structure 30. The first center of gravity 91 and/or the first (vertical) axis 93 of an electrically conductive element 40 are associated to the first amount of paste filled into a cavity 41 in the upper insulating layer structure 30 and the second center of gravity 92 and/or the second (vertical) axis 94 of an electrically conductive element 40 are associated to the second amount of paste filled into a cavity 41 in the lower insulating layer structure 30.

This allows to increase flexibility in the design and/or manufacturing of a component carrier according to the present invention.

**Fig. 9b** shows a schematic example of an electrically conductive element 40 in top view similar to Fig. 9a, wherein in this embodiment the conductive element 40, in particular one vertical extremity of the conductive element 40, has irregularity 97 externally protruding, in particular in one lateral direction perpendicular to stacking direction (for example in X direction), from the overall planar shape. Alternatively, the electrically conductive element 40 may have a plurality of irregularities 97 externally protruding from the overall planar shape. Due to the irregularity 97, the first center of gravity 91 (of the planar shape) may be decentered from the respective natural position 98 of the overall planar shape toward said irregularity 97. Preferably, the (circumferential) extension of the irregularity 97 may be of less than 40%, more preferably less than 20%, but more than 2% of the (circumferential) extension of the whole boundary profile of the vertical extremity. In an example, the at least one vertical extremity of the at least one electrically conductive element 40 may have a circumferential shape like a bibigon or a limacon when considering a planar view or top view. In an embodiment of the present invention, the lateral extension, in particular perpendicular to stacking direction Z, of the irregularity 97 is smaller than 30% of the average lateral extension, in particular to perpendicular to stacking direction Z, of one vertical extremity of the electrically conductive element 40, in particular the extremity where the irregularity 97 is located.

**Fig. 9c** shows a schematic example of an electrically conductive element 40 in three dimensional view similar to Fig. 9a and or Fig. 9b. As can be seen by Fig. 9c, a first irregularity 97 is associated to a one (vertical) extremity (for example the top extremity) of the electrically conductive element 40. Said first irregularity 97 protrudes in one lateral extension (for example X). Furthermore, a second irregularity 97 is associated to the opposed other vertical extremity (for example the bottom extremity) of the electrically conductive element 40. Said second irregularity 97 protrudes in the same lateral extension, however in opposed direction. Eventually, the second irregularity 97 may protrude in another lateral extension (for example Y), or in the same direction as the first irregularity 97. Similar to Fig. 9b, the first center of gravity 91 (of the planar shape) and/or the first (vertical) axis 93 may be decentered from the respective natural position 98 of the overall planar shape toward the first irregularity 97 and the second center of gravity 92 (of the planar shape) and/or the second (vertical) axis 94 may be decentered from the respective natural position 98 of the overall planar shape toward the second irregularity 97 (not shown). Additionally, the first irregularity 97 may be associated to the first amount of paste filled into a cavity 41 in the upper insulating layer structure 30 and a second irregularity 97 may be associated to the second amount of paste filled into a cavity 41 in the lower insulating layer structure 30. The shift of the first center of gravity 91 and/or the second center of gravity 92 and/or the creation of the first irregularity 97 and/or the second irregularity 97 may be a result of the applied shear forces Fₛₕ and/or the planarly sliding of the electrically conductive layer structure 10, 20 during the hot-pressing process step.

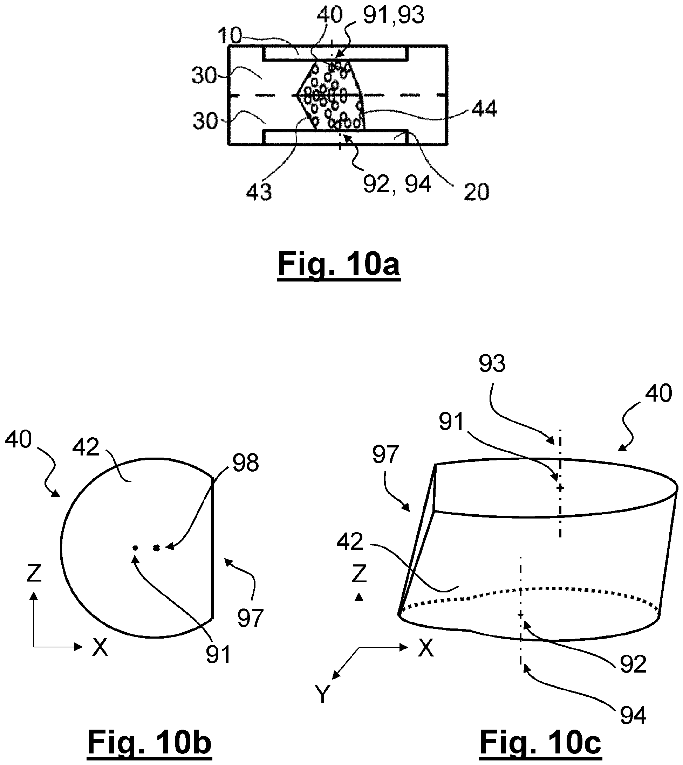

**Fig. 10a** shows a further schematic illustration of a further exemplary shape of the electrically conductive element 40 of a component carrier according to the present invention, which is similar as to that one illustrated in Fig. 9a, but wherein the conductive element 40 of this embodiment comprises a hexagonal shape, in particular an asymmetric or irregular hexagonal shape, instead of an hour-glass shape. The creation of the electrically conductive element 40 as shown in Fig. 9a and/or Fig. 10a may ensure a reliable electrical and/or mechanical connection even if the electrically conductive layer structures 10, 20 are not congruent and/or not exactly overlapping in stacking direction. The lateral shift of the adjacent electrically conductive layer structures 10, 20 may be a result of interactive shear forces occurring during manufacturing, in particular hot-pressing.

**Fig. 10b** shows a schematic example of an electrically conductive element 40 in top view similar to Fig. 10a, wherein in this embodiment the conductive element 40, in particular one vertical extremity of the conductive element 40, has irregularity 97 internally recessing inside, in particular in one lateral direction perpendicular to stacking direction (for example in X direction), the overall planar shape. Alternatively, the electrically conductive element 40 may have a plurality of irregularities 97 internally recessing inside the overall planar shape. Due to the irregularity 97, the first center of gravity 91 (of the planar shape) may be decentered from the respective natural position 98 of the overall planar shape away the irregularity 97. Preferably, the (circumferential) extension of the irregularity 97 may be of less than 40%, more preferably less than 20%, but more than 2% of the (circumferential) extension of the whole boundary profile of the vertical extremity. In an example, the at least one vertical extremity of the at least one electrically conductive element 40 may have a circumferential shape like a circular segment or a lune when considering a planar view or top view.

**Fig. 10c** shows a schematic example of an electrically conductive element 40 in three dimensional view similar to Fig. 10a and or Fig. 10b. As can be seen by Fig. 10c, a first irregularity 97 is associated to a one (vertical) extremity (for example the top extremity) of the electrically conductive element 40. Said first irregularity 97 recessing inside one lateral extension (for example X). Furthermore, a second irregularity 97 is associated to the opposed other vertical extremity (for example the bottom extremity) of the electrically conductive element 40. Said second irregularity 97 protrudes in the same lateral extension, however in opposed direction. Eventually, the second irregularity 97 may protrude in another lateral extension (for example Y) or in the same direction as the first irregularity 97. Similar to Fig. 10b, the first center of gravity 91 (of the planar shape) and/or the (vertical) axis 93 may be decentered from the respective natural position 98 of the overall planar shape away the first irregularity 97 and the second center of gravity 92 (of the planar shape) and/or the (vertical) axis 94 may be decentered from the respective natural position 98 of the overall planar shape toward the second irregularity 97 (not shown). Additionally, the first irregularity 97 may be associated to the first amount of paste filled into a cavity 41 in the upper insulating layer structure 30 and a second irregularity 97 may be associated to the second amount of paste filled into a cavity 41 in the lower insulating layer structure 30. The shift of the first center of gravity 91 and/or the second center of gravity 92 and/or the creation of the first irregularity 97 and/or the second irregularity 97 may be a result of the applied shear forces Fₛₕ and/or the planarly sliding of the electrically conductive layer structure 10, 20 during the hot-pressing process step. In an example, the first irregularity 97 and the second irregularity 97 may be located on the same lateral side of the electrically conductive element 40 (as shown in Fig. 10c). In another example, the first irregularity 97 and the second irregularity 97 may be located on different, in particular opposed, lateral side of the electrically conductive element 40 (as shown in Fig. 9c).

**Figs. 11****a** to **11c** show different examples of possible shapes of the electrically conductive element 40 of a component carrier 100 according to the present invention, wherein Fig. 11a and Fig. 11b each show a conductive element 40 with an irregular quadrangular shape, in particular with an irregular trapezoidal shape. The example of the electrically conductive element 40 illustrated in Fig. 11a is tilted to the right, wherein the electrically conductive element 40 exemplarily illustrated in Fig. 11b is tilted to the left.

Fig. 11c shows an electrically conductive element 40 having a rectangular or perpendicular trapezoidal shape with perpendicular inner angles α1, β1 (i.e. α1 = 90° and β1 = 90°). In an alternative embodiment, instead of angles α1, β1 respectively inclinations α1, β1, also angles α2 and β2 respectively the corresponding inclinations may be perpendicular (i.e. α2 = 90° and β2 = 90°).

As it is apparent from Figs. 11a to 11c, not only the inner angles α1 and α2 at the bottom side of contact element 40 defining the inclinations α1 and α2 relative to the contacting plane 21 (cf. Fig. 3) of electrically conductive layer structure 20 are different from each other, but also the inner angles β1 and β2 defining inclinations β1 and β2 relative to the other contacting plane 11 (cf. Fig. 3) of the electrically conductive layer structure 10 may be different from each other.

In at least one other embodiment, cavity 41 respectively the electrically conductive element 40 may alternatively have a parallelogram shape, a slanted shape, or a substantially trapezoidal shape (however not an ideally trapezoidal shape to ensure the different inclinations α1, α2 resp. β1, β2). In an example, the inner angles α1, α2, β1, β2 may be in the range between 35° to 155°, in particular between 45° to 135°. The difference of at least two inner angles, in particular when α is different to β, may result in a misalignment between the first center of gravity 91 and the second center of gravity 92.

**Fig. 12** shows a photo of a cross-section through a real embodiment of a component carrier 100 according to the present invention in the area of an electrically conductive element 40 with a preferred configuration of the electrically conductive element 40, wherein the dotted lines and the arrows have been added in order to emphasize the different inclinations α1 and α2. The configuration of component carrier 100 illustrated in Fig. 12 corresponds to the configuration of the component carrier 100 illustrated in Fig. 3, which has been explained in detail above.

Additionally, Fig. 12 also show layer structures 50 and 60, which are electrically insulating carrier structures 50, 60 made from an electrically insulating material.

Fig. 12 further shows that the metal particles of the electrically conductive paste 42 can at least be partially welded and/or sintered one to each other, wherein the concentration of the conductive particles in the conductive paste 42 can vary within the cavity 41.

As a result of the inhomogeneous distribution of the conductive particles within the conductive element 40, the conductivity of the electrically conductive element 40 can differ depending on the location with the conductive element 40, in particular in thickness direction Z.

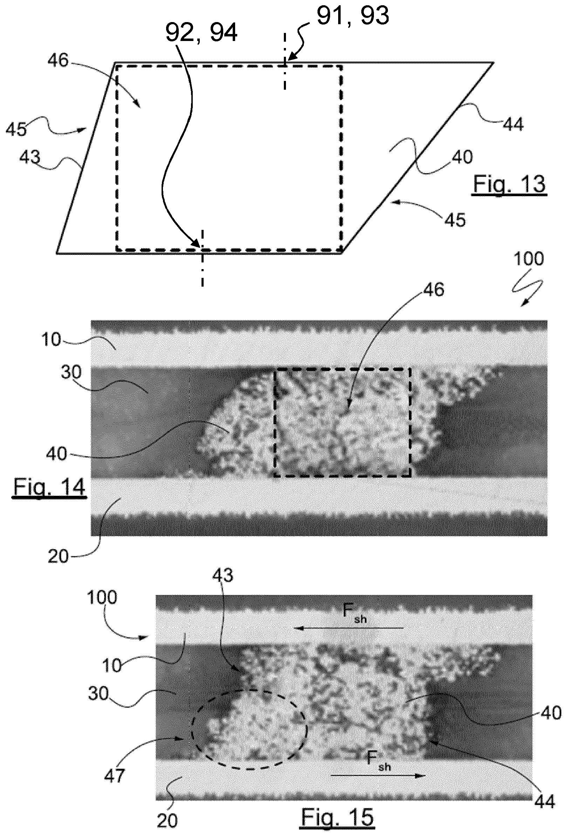

In some embodiments the concentration of the conductive particles within the conductive paste 40 in the cavity 41 may be higher in a core area what is illustrated in **Figs. 13** and **14****,** wherein **Fig. 13** shows a schematic illustration of an example of a core area 46 of the electrically conductive element 40 in which the particle concentration of the conductive particles of the conductive paste is higher.

Said core area 46 may in particular have a cube or square-shaped or a cylindrically shaped core volume 46, in particular a cube or square-shaped core volume 46 extending between the two extremities of the conductive element 40 thickness direction Z, i.e., a cube or square-shaped core volume 46 extending between the two electrically conductive layer structures 10, 20 (cf. Fig. 14) electrically connected by the electrically conductive element 40.

In a preferred embodiment, the concentration of conductive particles within the conductive paste in the cavity is in particular higher in a "perpendicular free portion" of the cavity between the two extremities of the at least one conductive element in thickness direction/stacking direction, i.e., in particular in that portion within the conductive element 40 not being limited in stacking direction by one of the lateral walls 45 or a portion 43, 44 thereof, wherein in this embodiment the perpendicular free portion also forms the core area 46 of the conductive element 40. The shift of the first center of gravity 91 and/or the second center of gravity 92 may be a result of the applied shear forces Fₛₕ and/or the planarly sliding of the electrically conductive layer structure 10, 20 during the hot-pressing process step. Thereby, the material of the electrically conductive element 40, in particular the electrically conductive paste 42, more in particular the electrically conductive particles 42a, may be at least partially be transported towards the direction of the sliding, then resulting in a peripheral lower amount of electrically conductive particles 42a with the respect to the core area /core volume 46, where the packing of these particles remain compact (one to each other).

**Fig. 14** shows a photo of a cross-section through a real embodiment of a component carrier 100 according to the present invention in the area of an electrically conductive element 40 corresponding to Fig. 13, wherein the dotted square has been added in order to emphasize the cube-shaped core area 46 with a higher density of electrically conductive particles within the electrically conductive element 40 respectively the electrically conductive paste 42.

**Fig. 15** shows a photo of a cross-section through a further real embodiment of a component carrier 100 according to the present invention in the area of an electrically conductive element 40 with a further possible configuration of the electrically conductive element 40. In this example, the concentration of the conductive particles is higher on the frontal inclined lateral wall 47 of the cavity 41, in particular at one extremity, in particular higher than on the rear inclined lateral wall 44, due to the higher shifting of the electrically conductive paste 42 toward the frontal inclined lateral wall 47 during the hot-pressing, wherein in order to emphasize the area with the higher density of electrically conductive particles within the electrically conductive element 40 the dotted ellipse has been added.

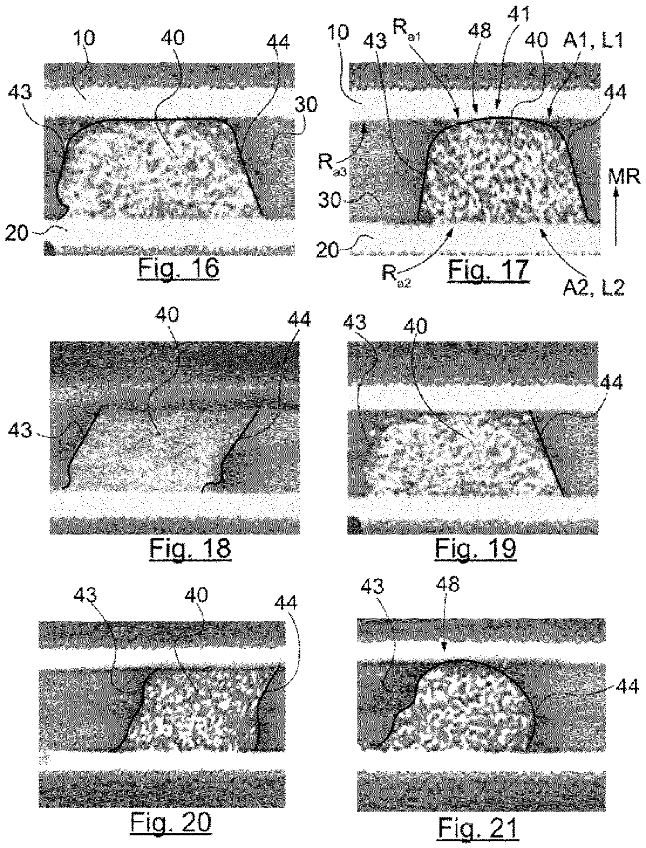

**Fig. 16** to **26** and **28** to **33** show photos of cross-sections through different real embodiments of component carriers 100 according to the present invention in an area of an electrically conductive element 40 with further possible configurations of the electrically conductive element 40, in particular with different shapes and configurations of the lateral wall 45 (cf. Fig. 3) respectively the interface zones between the electrically conductive element 40 and the surrounding layer structures 10, 20 and 30, wherein in order to emphasize the differences between the embodiments in some photos additional lines (solid and/or dotted) have been added.

**Fig. 16****,** for example, shows an embodiment with the conductive element 40 having a curved shape lateral wall portion 43 with different curvatures, wherein the opposed lateral wall portion 44 is substantially straight.

**Fig. 17** shows an embodiment with a cavity 41 respectively a conductive element 40 with a dimple 48 at the bottom of the cavity 41 in a material removal direction MR.

From this photo further different surface roughnesses Rₐ₁, Rₐ₂ and Rₐ₃ are visible, wherein in this example a first surface roughness Rₐ₁ of the surface of the electrically conductive layer structure 10 in the contact area A1 with the smaller extension L1 and/or of the dimple 48 is smaller than a second surface roughness Rₐ₂ of the surface of the electrically conductive layer structure 20 in the opposed contact area A2 with the larger extension L2 of the contact area A2. Alternatively (in another embodiment), the first surface roughness Rₐ₁ of the surface of the electrically conductive layer structure 10 in the contact area A1 may be similar, in particular the same, as or larger than the second surface roughness Rₐ₂ of the surface of the electrically conductive layer structure 20 in the opposed contact area A2 with the larger extension L2 of the contact area A2.

Further, the first surface roughness Rₐ₁ of the surface of the electrically conductive layer structure 10 in the contact area A1 with the smaller extension L1 and/or of the dimple 48 is smaller than a third surface roughness Rₐ₃ of the surface of the electrically conductive layer structure 10 surrounding said contact area A1. Alternatively (in another embodiment), the first surface roughness Rₐ₁ of the surface of the electrically conductive layer structure 10 in the contact area A1 may be similar, in particular the same, as or larger than third surface roughness Rₐ₃ of the surface of the electrically conductive layer structure 10 surrounding said contact area A1.

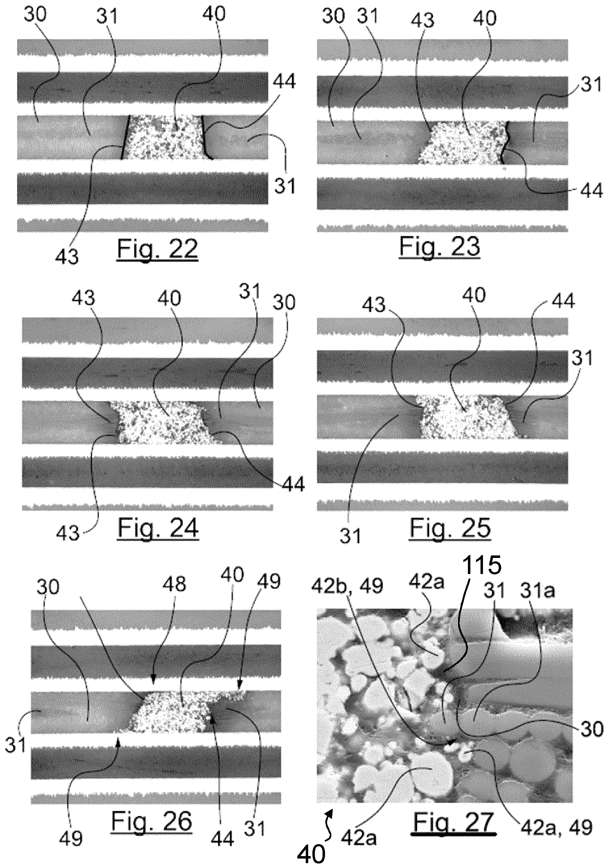

Some of the photos show that the electrically insulating layer structure 30, in which the cavity 41 is located, may comprise a resin with a filling structure 31 within said resin, e.g. reinforcement or stiffening fibers, cloth or fabric or the like, wherein the cavity 41 exposes at least a portion of said filling structure 31 so that said portion of the filling structure 31 contacts said conductive paste 42, see for example the photos in **Figs. 22** to **29** and **33** showing fibers 31a as filling structure 31.

The filling structure 31, in particular in case of fibers 31a, may penetrate or protrude into the conductive paste 42 in the cavity 41, i.e., the filling structure 31 may in particular protrude or penetrate into the conductive element 40. Therein, the filling structure 31 in particular may penetrate or protrude such into the conductive element 40 that some of the particles of the electrically conductive paste 42 are finally located in between the exposed filling structure 31, in particular in between the exposed fibers 31a.

**Fig. 22** shows exemplarily a conductive element 40 with a lateral wall portion 44 having a slanted shape.

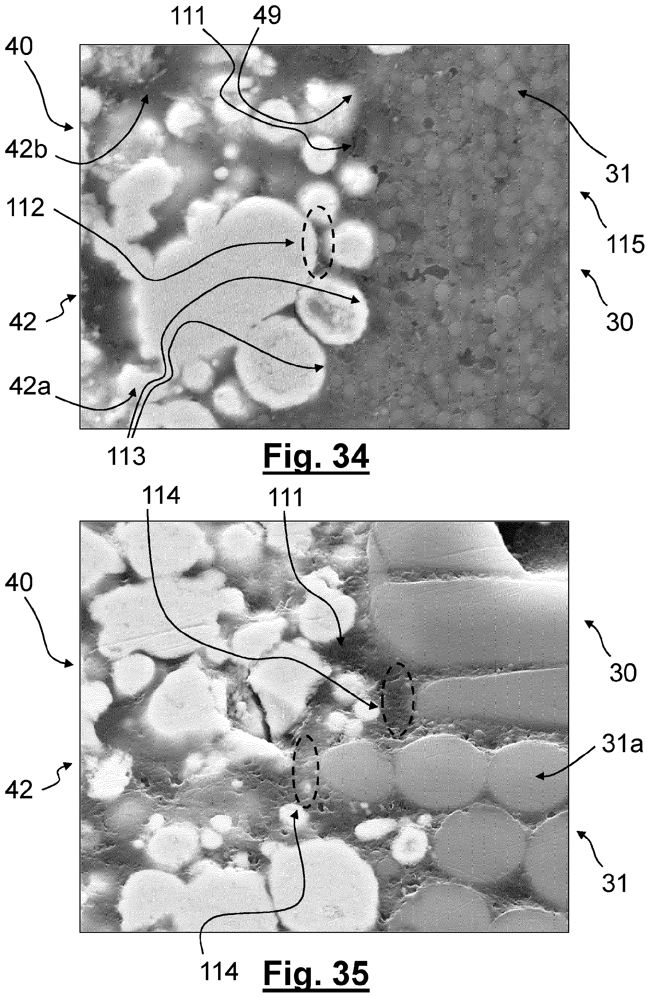

**Fig. 27** shows a scanning electron micrograph of a section through an embodiment of a component carrier in a transition region of the conductive element 40 and the electronically insulating layer structure 30, wherein the electrically insulating layer structure comprises glass fibers 31a. As can be seen by Fig. 27, the electrically conductive element 40 comprises a protrusion 49. The protrusion 49 of the electrically conductive element 40 may comprise electrically conductive particles 42a and/or matrix material 42b of the electrically conductive paste 42. Additionally, the electrically conductive element 40 may comprise at least one valley 111 and/or at least one undercut 112 (see Fig. 34). The protrusion 49 and/or valley 111 may be created since at least a portion of the electrically conductive paste 42, in particular the electrically conductive particles 42a, are pushed towards the adjacent electrically insulating layer structures 30 due to the applied shear forces Fₛₕ. Additionally or alternatively, fibers 31a may be pushed towards the electrically conductive element 40 and thereby may penetrate into the cavity 41 which is filled with the electrically conductive paste 42. In an example, metal particles 42a of the conductive paste 42 may be at least partially located between the fibers 31a of the filling structure 31 of the electrically insulating layer structure 30. In a further example, matrix material 42b may be at least partially located between the fibers 31a of the filling structure 31 of the electrically insulating layer structures 30. Additionally or alternatively, (in the boundary region) the resin material 115 of the electrically insulating layer structure 30 may be located between the electrically conductive particles 42a. This may be a result of the apparent forces during hot-pressing and/or due to complex flow behavior of the resin material 115, since during hot-pressing an elevated temperature, for example higher than 70 °C is involved, which in fact reduces the viscosity of the respective resin material influencing the flow behavior and thereby pushing the resin material 115 between electrically conductive particles 42a. Furthermore, due to the applied forces during hot-pressing, in particular pressure and/or shear force, deformation of the paste 42 and the adaptation of the shape of the conductive element 40 occurs. Thereby an uneven and/or structured surface profile of the lateral wall 45 of the electrically conductive element 40 may be created. In an example, the uneven and/or structured surface profile of the lateral wall 45 may comprise indentations and/or protrusions. This may enlarge the surface area of the electrically conductive element 40 and thereby a reliable adhesion between electrically conductive element 40 and the electrically conducting layer structure 30 may be ensured.

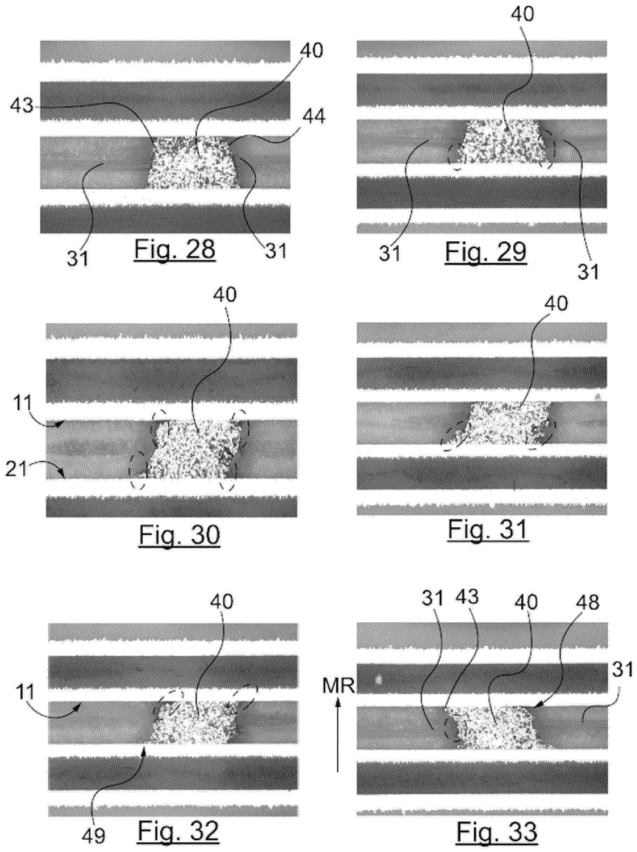

**Fig. 28** shows exemplarily a conductive element 40 with a substantially trapezoidal shape, wherein **Fig. 32****,** for example, shows exemplarily a conductive element 40 having a substantially parallelogram shape.

In some of the shown real embodiments, the exposed portion of the filling structure 31 disrupts a profile of the lateral wall 45 respectively of one of the opposed lateral wall portions 43, 44 of the insulating layer structure 30 delimiting the cavity 41 at least partially, see for example **Fig. 26** (here lateral wall portion 44 is disrupted by the fibers 31) or **Fig. 33** (here lateral wall portion 43 is disrupted by the fibers 31).

Some of the real embodiments show the electrically conductive paste 42 protruding into the surrounding electrically insulating layer structure 30, in particular adjacent to one of the electrically conductive layer structures 10, 20, see for example reference sign 49 in **Figs. 26****.**

Some embodiments of the component carrier 100 according to the present invention may comprise a plurality of cavities 41, each having a profile of the lateral wall 45 of the respective insulating layer structure 30 being disrupted by the respective filling structures 31, wherein the disrupted profiles of the pluralities of lateral wall 45 may in particular differ one from each other. In an example, the amount of the fibers 31a / filling structures 31, exposed in the cavity 41 of one electrically conductive element is different from the respective amount exposed in the cavity 41 of a further electrically conductive element. In another example, at least two, in particular the majority, of the plurality of electrically conductive elements 40 have shapes different one to each other. This may depend on the location of the electrically conductive element 40 in combination with the location of fibers 31a / filling structures 31. Therefore, each electrically conductive element may have a unique pattern of disruptions and/or pattern of exposure of fibers 31a / filling structure 31.

Since the filling structure 31 is substantially located in the central area of the insulating layer structure 30 with respect to the thickness direction Z, in particular if the filling structure 31 is made of or comprises fibers 31a as filler material, the disruption of the lateral wall profile in particular only occurs also in this central area.

**Fig. 34** shows a photo of a cross-section through a further real embodiment of a component carrier 100 according to the present invention in the area of an electrically conductive element 40. In this example, an interface region between the electrically conductive element 40 and the electrically insulating layer structure 30 is demonstrated. As can be seen, the electrically insulating layer structure 30 comprises a resin material 115. In an example, the resin material 115 may comprise an organic material, in particular an organic polymeric material, for example an epoxy resin. In another example, the resin material 115 may comprise an inorganic material. Preferably, the resin material 115 may be electrically insulating. Additionally, the electrically insulating layer structure 30 may comprise filling structures 31, for example rounded shaped particles and/or fibers 31a as can be seen by Fig. 34. In an example, the electrically insulating layer structure 30, in particular the filling structure 31/fillers, more in particular the particles and/or fibers 31a may comprise inorganic material, for example comprising Si and/or Br. Additionally or alternatively, the filling structure 31/fillers, more in particular the particles and/or fibers 31a may comprise Ba, Ca.

The at least one electrically conductive element 40 comprises an electrically conductive paste 42, in particular comprising electrically conductive particles 42a, which may be sintered and/or welded together with at least one respective other electrically conductive particle 42a. In an example, the electrically conductive paste 42, in particular the electrically conductive particles 42a, may comprise metal particles, in particular comprising at least one of: Cu, Ag, Au, Sn, Bi, or a combination thereof. Additionally or alternatively, the electrically conductive paste 42, in particular the electrically conductive particles 42a, may comprise organic material being electrically conductive, for example poly-3,4-ethylendioxythiophen (PEDOT), or other electrically conductive inorganic material, for example graphene or different metals not listed above, for example Cr, Al, Ti, Zn, or a combination thereof. Further additionally or alternatively, the electrically conductive particles 42a, may comprise a polymodal or monomodal size distribution. The electrically conductive paste comprises matrix material 42b, a resin material. The matrix material 42b of the electrically conductive paste 42 may comprise an organic material, in particular an organic polymeric material, for example an epoxy resin. In an example the material of the matrix material 42b may be similar, in particular the same, as the resin material 115 of the electrically insulating layer structure 30. Alternatively, the matrix material 42b may be different then the resin material 115 of the electrically insulating layer structure 30. Additionally, the electrically conductive paste 42 may be free from further filling material. The electrically conductive element 40, in particular at least a portion of the lateral wall 44, 45 laterally may extend along an irregular profile. Said irregular profile may define at least one valley 111. Additionally, at least portion of the electrically conductive element 40, in particular the electrically conductive paste 42, more in particular the electrically conductive particle 42a, may create at least one protrusion 49. The dimension of the valley 111 and/or protrusion 49 may be in the smaller than 100 µm, in particular smaller than 30 µm. Alternatively, the dimension of the valley 111 and/or protrusion 49 may be in the range between 100 µm to 500 µm. As can be seen in Fig. 34, the at least one electrically conductive element 40 laterally extends following the contour of the metal particles 42a. The specific product feature, wherein the at least one electrically conductive element laterally extending following the (contour of) metal particles is depicted by reference number 113. In a preferred example, the valleys 111 extend toward the electrically conductive paste 42 defining undercuts 112 hidden by external metal portions. One undercut 112 can be seen in Fig.34 by the dotted ellipse. The electrically insulating layer structure 30, in particular the resin material 115 of the electrically insulating layer structure 30, may at least partially fill the irregular profile, in particular the valley 111 and/or the undercut 112. Alternatively, the electrically conductive element 40 may have a portion extending in a substantially straight direction.

**Fig. 35** shows a photo of a cross-section through a further real embodiment of a component carrier 100 according to the present invention in the area of an electrically conductive element 40. In this example, an interface region between the electrically conductive element 40 and the electrically insulating layer structure 30 is demonstrated. As in Fig. 34, in Fig. 35 the electrically insulating layer structure 30 comprises filling structures 31, in particular fibers 31a. As can be seen in Fig. 35, a plurality of said fillers are provided at the irregular profile of the at least one electrically conductive element 40, in particular at least partially within the valleys 111 defined by said profile. Preferably, the lateral extension of the at least one electrically conductive element 40 may be affected by said fillers/filling structure 31. Thereby the filling structure 31 may disrupt the lateral extension at the portion of the electrically conductive element 40 where the filling structure 31 is exposed from the (electrically insulating) material of the electrically insulating layer structure 30. In an example, the filling structure 31, which disrupts the lateral extension at the portion of the electrically conductive element 40, may comprise fibers 31a (see Fig. 35). Additionally or alternatively, the filling structure 31, which disrupts the lateral extension at the portion of the electrically conductive element 40, may comprise particles. Preferably, the resin material 115 of the electrically insulating layer structure 30, which is in contact with the fibers 31a or the particles may protrude toward the electrically conductive element 40, in particular the electrically conductive paste 42. The resin material of the electrically insulating layer structure which is in contact with the fibers or the particles protruding toward the electrically conductive element, in particular the electrically conductive paste, is depicted by reference number 114 and can be seen by the dotted ellipse.

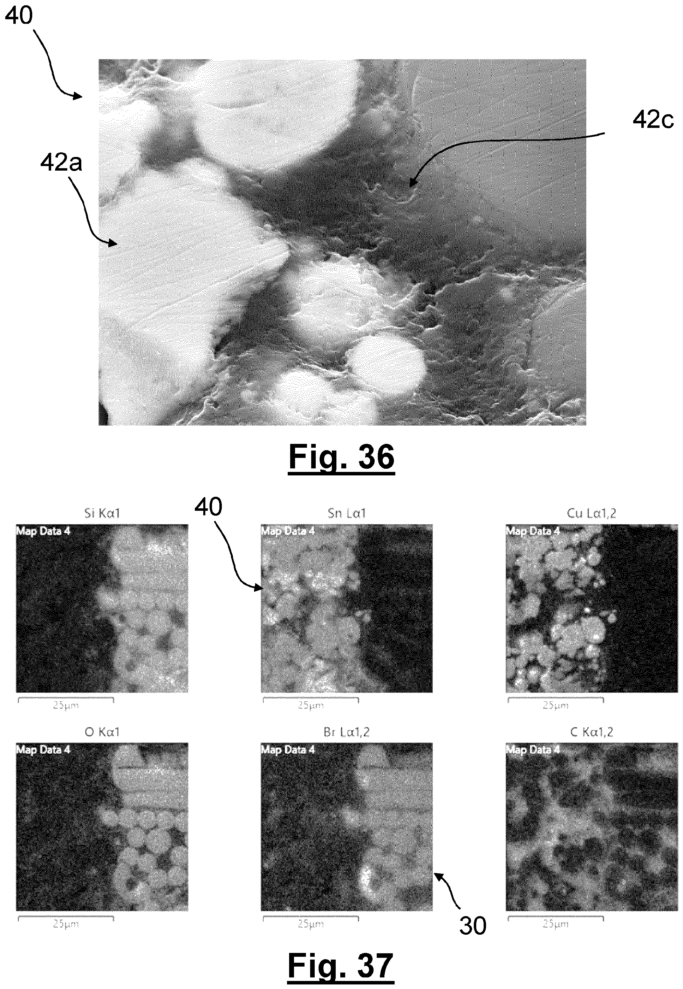

**Fig. 36** shows a photo of a cross-section through a further real embodiment of a component carrier 100 according to the present invention in the area of an electrically conductive element 40. In this example, a center region inside the electrically conductive paste 42 is demonstrated. Fig. 36 shows a region between adjacent electrically conductive particles 42a, which is filled by a particle free resin 42c. In other words, in the center region of the conductive paste 42 only resin without fillers may be provided. The electrically conductive particles 42a may be sintered and/or welded together. Additionally, the center region may comprise a particle free resin 42c having gas filled cavities and/or pores.

**Fig. 37** respectively shows results of a chemical element analysis regarding a cross-section of a component carrier 100, according to an exemplary embodiment of the invention. For these measurements, a photo of a cross-section was generated using scanning electron microscope (SEM). Moreover, energy dispersive X-ray spectroscopy has been applied to the same photo generated by the SEM. Each Figure shows a distribution of a specific chemical element. The photo relates to a region of the component carrier 100, showing an interface region between the electrically conductive element 40 and the electrically insulating layer structure 30, similar to Fig. 34 and Fig. 35. The brighter portions in the respective photo demonstrates element enriched portions and can be related to a relative amount/concentration of the specific element. As can be seen in the top middle photo and top right photo, a bigger portion of the left-handed side of the photo comprises Sn and Cu, indicating the electrically conductive element 40, in particular the electrically conductive paste comprising the electrically conductive particles 42a. The top left photo, bottom left photo and bottom middle photo shows that a bigger portion of the right-handed side of the photo comprises Si, O and Br indicating the electrically insulating layer structure 30, in particular the filling structure 31. Additionally, the bottom right photo shows that over the entire photo brighter regions can be found. This indicates that C can be found in the region associated to the electrically conductive element 40 and the electrically insulating layer structure 30. This may further indicate that an inorganic carbon containing matrix and/or organic carbon containing matrix, for example an organic polymer, may be used as a molding material. Fig. 37 also shows that the boundary region of the at least one electrically conductive element 40 comprises the metal of the electrically conductive paste 42, the organic material, in particular the particle free resin 42c, of the electrically conductive paste 42 and the material, in particular the resin material 115 and/or the material or the fillers/filling structure 31, of the at least one electrically insulating layer structure 30. Additionally, the boundary region of the at least one electrically conductive element 40 may comprise the first metal, in particular Cu, Ag, or Au of the electrically conductive paste 42, the second metal, in particular Sn, Zn, Bi or Al, of the electrically conductive paste 42, the organic material, in particular the particle free resin 42c, of the electrically conductive paste 42 and the material, in particular the resin material 115 and/or the material or the fillers/filling structure 31, of the at least one electrically insulating layer structure 30. Furthermore, which can be also seen by Fig. 37, is that the amount of the second metal, in particular Sn, Bi, Zn, or Al, in the boundary region in contact with the at least one electrically insulating layer structure 30, in particular with the respective filler/filling structure 31, is higher than the respective amount of the first metal, in particular Cu, Ag, or Au, in contact with said at least one electrically insulating layer 30. Preferably, the majority of the metal in contact with the exposing filling structure 31, in particular the particles and/or fibers 31a (see figures 27 and 35), of the electrically insulating layer structure 30 is the second metal, in particular Sn, Bi, Zn, or Al. Alternatively, the majority of the metal in contact with the exposing filling structure 31, in particular the particles and/or fibers 31a, of the electrically insulating layer structure 30 may be the first metal, in particular Cu, Ag, or Au. In the content of this document, the term "first metal" may refer to a metal or alloy having a melting point higher than 700 °C, in particular higher than 800 °C. In an example, the second may be Cu, Ag, Au, or Cr. In another example, the second metal may be brass or red gold. In the content of this document the term "second metal" may refer to a metal or alloy having a melting point smaller than 700 °C. In an example, the first metal may be Sn, Bi, Zn, or Al. In another example, the first metal may an alloy, for example Babbitt or Aluminum Bronze.

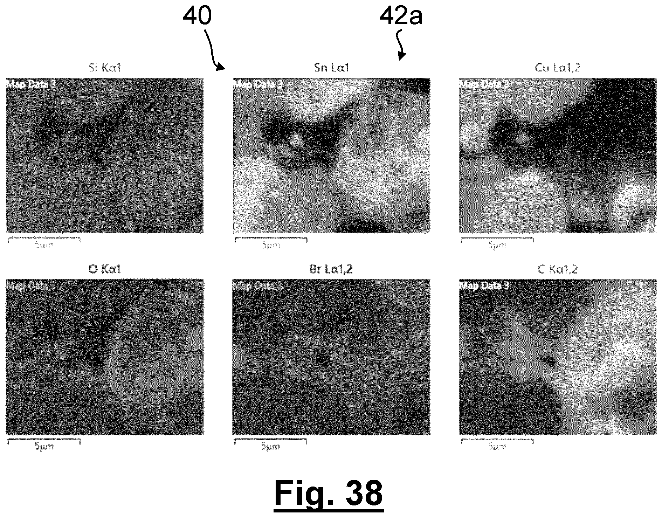

**Fig. 38** respectively show results of a chemical element analysis regarding a cross-section of a component carrier 100, according to an exemplary embodiment of the invention. For these measurements, a photo of a cross-section was generated using scanning electron microscope (SEM). Moreover, energy dispersive X-ray spectroscopy has been applied to the same photo generated by the SEM. Each Figure shows a distribution of a specific chemical element. The photo relates to a region of the component carrier 100, showing a center region inside the electrically conductive element 40, similar to Fig. 36. The brighter portions in the respective photo may demonstrate element enriched portions and may be related to a relative amount/concentration of the specific element. In comparison to Fig. 37, more than 50% of the area in the top right photo comprises Cu. This may be related to a relative Cu concentration, for example higher than 50 w%, in particular higher than 60 w%. Less than 30% the area of the photo can be associated to C and Sn (bottom right photo and top middle photo). Less than 20% the area of the photo can be associated to Si, O, Br (top left photo, bottom left photo, bottom middle photo). This may indicate that in the center region of the electrically conductive element 40 a high concentration of metal, for example higher than 70 w%, in particular higher than 80 w%, may be located which may be fixed by an organic resin as molding material, for example the particle free resin 42c. By comparison between Fig. 37 and Fig. 38, it can be preferably observed that the ratio between the two metals, in particular between the first metal and the second metal, more in particular between copper and tin, in the central region is different from the ratio at the respective boundary region of the at least one electrically conductive element 40.Preferably, the amount of the first metal, in particular copper, in the central region of the at least one electrically conductive element 40 is higher, in particular 10% more and/or 10 w% more, in particular 20% more and/or 20 w% more, than the amount of the second metal, in particular tin, in the respective central region. Preferably, the amount of the second metal, in particular tin, in the boundary region of the at least one electrically conductive element is higher, in particular 10% more and/or 10 w% more, in particular 20% more and/or 20 w% more, than the amount of the first metal, in particular copper, in the respective boundary region. The exemplary photos shown in Fig. 35 to Fig. 38 may be a result of applying a lamination and/or hot-pressing step during manufacturing of the component carrier 100 having an electrically conductive element 40 comprising electrically conductive paste 42, in particular electrically conductive particles 42a. During hot-pressing the second metal, in particular Sn or Bi, may at least partially melt whereas the first metal, in particular Cu, Ag or Au may not melt. Due to the applied shear forces Fₛₕ the second metal may have different inertia compared to the first metal and thus may have different flow behavior during hot-pressing resulting in different metal distribution of the first metal and the second metal in the respective center region and/or the boundary region. Additionally or alternatively, the electrically insulating layer structure 30, in particular the resin material 115 and/or the fillers/filling structure 31 may be more likely in direct contact with the second metal compared to the first metal. The relatively low viscosity of the particle free resin 42c of the electrically conductive paste 42 and/or the resin material 115 of the electrically insulating layer structure 30 compared to the other materials of the electrically conductive element 40 may influence the final shape of the electrically conductive element 40 due to its/their complex flow behavior during hot-pressing. Since the electrically conductive element 40 tends to reduce internal stress and/or pressure, the vertical extremity comprising the first center of gravity 91 and the opposed other vertical extremity comprising the second center of gravity 92 may be misaligned.

Implementation of the invention is not limited to the preferred embodiments shown in the figures and described above. Instead, a multiplicity of variants is possible which use the solutions shown and the principle according to the invention, whose scope is defined by the appended claims.

### LIST OF REFERENCE SIGNS

- 1: component carrier as known from prior art

- 100,.., 400: component carrier according to the present invention
- 101: stack
- 10, 20: electrically conductive layer structure
- 11, 21: contacting plane
- 30: electrically insulating layer structure
- 31: filling structure
- 31a: fibers
- 40: electrically conductive element, via
- 40': defect / failure in electrical connection or conductive element
- 41: cavity
- 42: electrically conductive paste
- 42a: electrically conductive (metal) particles
- 42b: matrix material of the conductive paste (e.g. resin)
- 42c: particle free resin
- 43, 44: portion of the lateral wall
- 45: lateral wall
- 46: core area, in particular cube-shaped volume
- 47: frontal inclined lateral wall
- 48: dimple
- 49: protrusion
- 50, 60: carrier layer structure (insulating layer structure)
- 50': first sub-carrier
- 60': second sub-carrier
- 70: further layer structure
- 80: protective layer structure
- 90: plated via
- 91: first center of gravity
- 92: second center of gravity
- 93: first (vertical) axis
- 94: second (vertical) axis
- 95: further (virtual) axis 95 passes through the first center of gravity and the second center of gravity
- 96: virtual axis of the cavity in the electrically insulating layer
- 97: irregularity
- 98: natural position
- 111: valley
- 112: undercut
- 113: the at least one electrically conductive element laterally extending following the (contour of) metal particles
- 114: resin material of the electrically insulating layer structure, which is in contact with the fibers, protruding toward the electrically conductive paste
- 115: resin of the electrically insulating layer structure

- α1: first inclination
- α2: second inclination
- β1: third inclination
- β2: fourth inclination
- y: fifth inclination
- A1: first contact area
- A2: second contact area
- D: planar offset (of the misalignment)
- Fₕₒₜ: hot-pressing force
- Fₛₕ: shrinking / shearing force
- L1: first length
- L2: second length
- MR: material removal direction
- Rₐ₁, Rₐ₂, Rₐ₃: surface roughness
- X: lateral direction, first direction
- Y: lateral direction, second direction
- Z: thickness direction (Z), stacking direction

## Claims

1. A component carrier (100, 200, 300, 400), wherein the component carrier comprises:
a stack (101) comprising at least one electrically insulating layer structure (30) and at least two electrically conductive layer structures (10, 20),
at least one electrically conductive element (40), said at least one electrically conductive element (40) passing through said at least one electrically insulating layer structure (30), said at least one electrically conductive element (40) comprising an electrically conductive paste (42) provided in a cavity (41) being located at least partially within the at least one electrically insulating layer structure (30), said electrically conductive paste (42) being in contact with said at least two electrically conductive layer structures (10, 20),
wherein the center of gravity (91) of one vertical extremity of the at least one electrically conductive element (40) is misaligned with respect to the center of gravity (92) of the opposed other vertical extremity of said at least one electrically conductive element (40).

2. The component carrier (100, 200, 300, 400) according to the claim 1, wherein the misalignment is at least partially along the stack thickness direction (Z), in particular wherein the axis (95) passing through the center of gravity (91, 92) of each one of the two vertical extremities of the at least one electrically conductive element (40) is inclined with respect to one of the stack main surfaces of an angle (γ) different from 90°.

3. The component carrier (100, 200, 300, 400) according to any of claims 1 to 2, wherein the planar shape of at least one of the two vertical extremities of the at least one electrically conductive element (40) comprises at least one irregularity (97) externally protruding from the overall planar shape, the center of gravity (91, 92) of said planar shape being decentered from the respective natural position (98) of the overall planar shape toward said irregularity (97).

4. The component carrier (100, 200, 300, 400) according to any of claims 1 to 3, wherein the planar shape of at least one of the two vertical extremities of the at least one electrically conductive element (40) comprises at least one irregularity (97) internally recessing inside the overall planar shape, the center of gravity (91, 92) of said planar shape being decentered from the respective natural position (98) of the overall planar shape away the irregularity (97).

5. The component carrier (100, 200, 300, 400) according to any of claims 1 to 4, wherein said at least one electrically conductive element (40) laterally extends along an irregular profile, in particular defining valleys (111).

6. The component carrier (100, 200, 300, 400) according to claim 5, wherein said conductive paste (42) comprises metal particles (42a), said at least one electrically conductive element (40) laterally extending following said metal particles (42a).

7. The component carrier (100, 200, 300, 400)according to any of claims 1 to 6, wherein said at least one electrically insulating layer structure (30) comprises fillers, said fillers comprise fibers (31a), said fibers (31a) in particular being configured as forming a reinforcing cloth embedded in the at least one electrically insulating layer structure (30), wherein said fibers (31a) protrude toward the paste disrupting the lateral extension of the at least one electrically conductive element.

8. The component carrier (100, 200, 300, 400) according to claim 7, wherein at least one electrically insulating layer structure (30) comprises resin (115), a portion of resin in contact with said fibers protrudes toward the electrically conductive paste (114).

9. The component carrier (100, 200, 300, 400) according to any of claims 1 to 8, wherein the conductive paste (42) comprises at least two metals, in particular two among copper, silver, gold, tin, bismuth.

10. The component carrier (100, 200, 300, 400) according to claim 9, wherein the ratio between the two metals in the central region is different from the ratio at the respective boundary region of the at least one electrically conductive element (40).

11. The component carrier (100, 200, 300, 400) according to claim 10, wherein the amount of the second metal in the boundary region in contact with the at least one electrically insulating layer structure (30), in particular with the respective filler, is higher than the respective amount of the first metal in contact with said at least one electrically insulating layer (30).

12. The component carrier (100, 200, 300, 400) according to any of claims 1 to 11, comprising a plurality of electrically conductive elements (40) passing through said at least one electrically insulating layer structure (30), each of said plurality of electrically conductive elements (40) comprising a cavity (41) filled by a conductive paste (42), wherein the center of gravity (91) of one vertical extremity of the electrically conductive elements (40) is misaligned with respect to the respective center of gravity (92) of the opposed other extremity of said electrically conductive elements (40).

13. The component carrier (100, 200, 300, 400) according to any of claims 12, wherein the misalignment of the gravity center (92) of the opposed vertical extremities of each electrically conductive element of said plurality of electrically conductive elements (40) are misaligned of the same value of and/or toward the same direction within a tolerance of 5%-20% of the misalignment value and/or angle (α).

14. A method of manufacturing a component carrier (100, 200, 300, 400), comprising the steps of:
forming a stack (101) comprising at least one electrically insulating layer structure (30) and at least two electrically conductive layer structures (10, 20),
forming at least one electrically conductive element (40), said at least one electrically conductive element (40) passing through said at least one electrically insulating layer structure (30), said at least one electrically conductive element (40) comprising an electrically conductive paste (42) provided in a cavity (41) being located at least partially within the at least one electrically insulating layer structure (30), said electrically conductive paste (42) being in contact with said at least two electrically conductive layer structures (10, 20),
wherein the center of gravity (91) of one vertical extremity of the at least one electrically conductive element (40) is misaligned with respect to the center of gravity (92) of the opposed other vertical extremity of said at least one electrically conductive element (40).

15. The method according to claim 14, comprising the steps of laminating, in particular applying pressure and more in particular also temperature on the stack (101), allowing the layers (10, 20, 30) to be pressed and to planarly slide along one to each other during the lamination.
